(19) Europäisches Patentamt / European Patent Office / Office européen des brevets

(11) **EP 4 674 921 A1**

(12) **EUROPEAN PATENT APPLICATION**
published in accordance with Art. 153(4) EPC

(43) Date of publication:
07.01.2026 Bulletin 2026/02

(21) Application number: 24763870.3

(22) Date of filing: 27.02.2024

(51) International Patent Classification (IPC):
C09J 133/04 (2006.01)     C09J 7/38 (2018.01)
C09J 11/04 (2006.01)      C09J 11/06 (2006.01)
C09J 11/08 (2006.01)      H01L 21/301 (2006.01)

(52) Cooperative Patent Classification (CPC):
C09J 7/38; C09J 11/04; C09J 11/06; C09J 11/08;
C09J 133/04; H01L 21/30

(86) International application number:
PCT/JP2024/006916

(87) International publication number:
WO 2024/181390 (06.09.2024 Gazette 2024/36)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 01.03.2023 JP 2023031137

(71) Applicant: Sekisui Chemical Co., Ltd.
Osaka-shi, Osaka 530-8565 (JP)

(72) Inventors:
• ZHANG, Ye
  Mishima-gun, Osaka 618-0021 (JP)
• UEDA, Kozo
  Mishima-gun, Osaka 618-0021 (JP)
• OGATA, Yudai
  Mishima-gun, Osaka 618-0021 (JP)
• TAKIJIRI, Aya
  Inukami-gun, Shiga 522-0314 (JP)

(74) Representative: Cabinet Beau de Loménie
103, rue de Grenelle / CS 90800
75340 Paris Cedex 07 (FR)

(54) **ADHESIVE COMPOSITION, ADHESIVE TAPE, METHOD FOR PROCESSING SEMICONDUCTOR WAFER, AND METHOD FOR PRODUCING SEMICONDUCTOR DEVICE**

(57)    The present invention aims to provide an adhesive composition that can achieve both excellent filling properties for irregularities and excellent removability. The present invention also aims to provide an adhesive tape including an adhesive layer containing the adhesive composition. The present invention also aims to provide a method for processing a semiconductor wafer using the adhesive tape and a method for producing a semiconductor device using the adhesive tape. Provided is an adhesive composition containing a (meth)acrylic copolymer, the (meth)acrylic copolymer containing a structural unit derived from n-heptyl (meth)acrylate, the (meth)acrylic copolymer having a carbon-carbon double bond in a side chain.

EP 4 674 921 A1

## Description

TECHNICAL FIELD

The present invention relates to an adhesive composition. The present invention also relates to an adhesive tape including an adhesive layer containing the adhesive composition. The present invention also relates to a method for processing a semiconductor wafer using the adhesive tape and a method for producing a semiconductor device using the adhesive tape.

BACKGROUND ART

Adhesive tapes including adhesive layers containing adhesive compositions have been widely used to fix components in electronic devices, vehicles, houses, and building materials (see Patent Literatures 1 to 3, for example). Specifically, for example, adhesive tapes are used to bond a cover panel for protecting a surface of a portable electronic device to a touch panel module or display panel module, or to bond a touch panel module to a display panel module.

CITATION LIST

- Patent Literature

    Patent Literature 1: JP 2015-052050 A
    Patent Literature 2: JP 2015-021067 A
    Patent Literature 3: JP 2015-120876 A

SUMMARY OF INVENTION

- Technical Problem

Widely used conventional adhesive compositions with excellent adhesion include acrylic adhesives containing (meth)acrylic copolymers. Examples of acrylic monomers constituting such (meth)acrylic copolymers include alkyl (meth) acrylates such as butyl (meth)acrylate and 2-ethylhexyl (meth)acrylate.

Adhesive compositions or adhesive tapes used for temporarily fixing semiconductors or other electronic components require excellent filling properties for irregularities because bump wafers or other components to be temporarily fixed have irregular surfaces. In addition, adhesive compositions or adhesive tapes also require excellent removability, as they need to be removable from the temporarily fixed electronic component while preventing or reducing adhesive deposits (residues).

Unfortunately, acrylic adhesives containing (meth)acrylic copolymers mainly made of butyl (meth)acrylate have insufficient filling properties for irregularities. Acrylic adhesives containing (meth)acrylic copolymers mainly made of 2-ethylhexyl (meth)acrylate have excellent filling properties for irregularities, but easily tear upon removal and tend to leave adhesive deposits on the temporarily fixed electronic component.

The present invention aims to provide an adhesive composition that can achieve both excellent filling properties for irregularities and excellent removability. The present invention also aims to provide an adhesive tape including an adhesive layer containing the adhesive composition. The present invention also aims to provide a method for processing a semiconductor wafer using the adhesive tape and a method for producing a semiconductor device using the adhesive tape.

- Solution to Problem

The disclosure 1 relates to an adhesive composition containing a (meth)acrylic copolymer, the (meth)acrylic copolymer containing a structural unit derived from n-heptyl (meth)acrylate, the (meth)acrylic copolymer having a carbon-carbon double bond in a side chain.

The disclosure 2 relates to the adhesive composition according to the disclosure 1, wherein the structural unit derived from n-heptyl (meth)acrylate is contained in a proportion of 15% by mass or more in the (meth)acrylic copolymer.

The disclosure 3 relates to the adhesive composition according to the disclosure 1 or 2, wherein the (meth)acrylic copolymer has a carbon-carbon double bond equivalent of 0.05 meq/g or greater.

The disclosure 4 relates to the adhesive composition according to the disclosure 1, 2, or 3, wherein the (meth)acrylic copolymer contains a structural unit derived from a polar functional group-containing monomer.

The disclosure 5 relates to the adhesive composition according to the disclosure 4, wherein the structural unit derived from a polar functional group-containing monomer is contained in a total proportion of 0.01% by mass or more and 30% by mass or less in the (meth)acrylic copolymer.

The disclosure 6 relates to the adhesive composition according to the disclosure 4 or 5, wherein the (meth)acrylic copolymer has an acid value of 10 mg KOH/g or less.

The disclosure 7 relates to the adhesive composition according to the disclosure 4, 5, or 6, wherein the (meth)acrylic copolymer has a hydroxy value of 5 mg KOH/g or greater and 100 mg KOH/g or less.

The disclosure 8 relates to the adhesive composition according to the disclosure 1, 2, 3, 4, 5, 6, or 7, wherein the (meth)acrylic copolymer has a weight average molecular weight of 200,000 or greater and 2,000,000 or less.

The disclosure 9 relates to the adhesive composition according to the disclosure 1, 2, 3, 4, 5, 6, 7, or 8, further containing a photopolymerization initiator.

The disclosure 10 relates to the adhesive composition according to the disclosure 1, 2, 3, 4, 5, 6, 7, 8, or 9, further containing an inorganic filler.

The disclosure 11 relates to the adhesive composition according to the disclosure 1, 2, 3, 4, 5, 6, 7, 8, 9, or 10, further containing a polyfunctional oligomer or a polyfunctional monomer.

The disclosure 12 relates to the adhesive composition according to the disclosure 1, 2, 3, 4, 5, 6, 7, 8, 9, 10, or 11, further containing a gas generating agent.

The disclosure 13 relates to the adhesive composition according to the disclosure 1, 2, 3, 4, 5, 6, 7, 8, 9, 10, 11, or 12, further containing a tackifier.

The disclosure 14 relates to an adhesive tape including an adhesive layer containing the adhesive composition according to the disclosure 1, 2, 3, 4, 5, 6, 7, 8, 9, 10, 11, 12, or 13.

The disclosure 15 relates to the adhesive tape according to the disclosure 14, wherein the adhesive layer has a bio-derived carbon content of 10% or more.

The disclosure 16 relates to the adhesive tape according to the disclosure 14 or 15, wherein the adhesive layer has a gel fraction of 10% by mass or more and 90% by mass or less, and the adhesive layer has a gel fraction of 90% by mass or more after heating at 150°C for one hour or after irradiation with light of any of the wavelengths in the range from 280 nm to 405 nm at an accumulated light dose of 1,000 mJ/cm$^2$ or greater.

The disclosure 17 relates to the adhesive tape according to the disclosure 14, 15, or 16, wherein the adhesive layer has a shear storage modulus at 23°C of $1.2 \times 10^5$ Pa or less, and the adhesive layer has a tensile storage modulus at 23°C of $1.0 \times 10^6$ Pa or greater after heating at 150°C for one hour or after irradiation with light of any of the wavelengths in the range from 280 nm to 405 nm at an accumulated light dose of 1,000 mJ/cm$^2$ or greater.

The disclosure 18 relates to the adhesive tape according to the disclosure 14, 15, 16, or 17, wherein the adhesive tape has a 180° peeling force for SUS of 0.3 N/25 mm or greater, and the adhesive tape has a 180° peeling force for SUS of 0.3 N/25 mm or less after heating at 150°C for one hour or after irradiation with light of any of the wavelengths in the range from 280 nm to 405 nm at an accumulated light dose of 1,000 mJ/cm$^2$ or greater.

The disclosure 19 relates to the adhesive tape according to the disclosure 14, 15, 16, 17, or 18, which is used for temporarily fixing a semiconductor wafer.

The disclosure 20 relates to a method for processing a semiconductor wafer, including the step of temporarily fixing a semiconductor wafer to a support using the adhesive tape according to the disclosure 19, curing the adhesive layer with light or heat, and then removing the adhesive tape.

The disclosure 21 relates to a method for producing a semiconductor device, including the step of temporarily fixing a semiconductor wafer to a support using the adhesive tape according to the disclosure 19, curing the adhesive layer with light or heat, and then removing the adhesive tape.

The present invention is described in detail below.

The present inventors found out that an adhesive composition containing a (meth)acrylic copolymer containing a structural unit derived from n-heptyl (meth)acrylate has improved filling properties for irregularities and improved removability. Moreover, the inventors focused on the fact that curing the (meth)acrylic copolymer greatly decreases the adhesion of the adhesive composition and improves the removability. The inventors considered further enhancing the removability of the adhesive composition by introducing carbon-carbon double bonds into side chains of the (meth)acrylic copolymer containing a structural unit derived from n-heptyl (meth)acrylate and thus making the (meth)acrylic copolymer curable by light irradiation, heating, or the like.

As a result, the inventors found that the resulting adhesive composition can achieve both excellent filling properties for irregularities and excellent removability, and thus completed the present invention.

The adhesive composition of the present invention contains a (meth)acrylic copolymer.

The (meth)acrylic copolymer contains a structural unit derived from n-heptyl (meth)acrylate.

n-Heptyl (meth)acrylate can decrease the glass transition temperature (Tg) of a polymer and increase its flexibility. Therefore, with the (meth)acrylic copolymer containing a structural unit derived from n-heptyl (meth)acrylate, the adhesive composition of the present invention can have excellent filling properties for irregularities and be easily removed from an irregular surface while preventing or reducing adhesive deposits, thus exhibiting excellent removability.

The "(meth)acrylic" herein means acrylic or methacrylic. The "(meth)acrylate" means acrylate or methacrylate.

The depletion of petroleum resources and the emission of carbon dioxide from the combustion of petroleum-derived products have been of concern in recent years. Attempts have been made to conserve petroleum resources by substituting bio-derived materials for petroleum-derived materials.

Thus, the n-heptyl (meth)acrylate preferably contains bio-derived carbon. The n-heptyl (meth)acrylate containing bio-derived carbon can increase the bio-derived carbon content in the adhesive layer (described later) containing the adhesive composition of the present invention, so that the adhesive tape including the adhesive layer causes less environmental load.

The phrase "containing bio-derived carbon" herein means that the bio-based carbon content of a compound measured in conformity with ASTM D6866-22 is 1% or higher.

The n-heptyl (meth)acrylate containing bio-derived carbon in the structural unit derived from n-heptyl (meth)acrylate is preferably synthesized by esterification of n-heptyl alcohol that is a bio-derived material and (meth)acrylic acid. The n-heptyl (meth)acrylate containing bio-derived carbon is also preferably synthesized by transesterification of n-heptyl alcohol that is a bio-derived material and a (meth)acrylate.

The n-heptyl alcohol that is a bio-derived material can be inexpensively and easily available by cracking a raw material collected from an animal or a plant (e.g., ricinoleic acid derived from castor oil).

The lower limit of the proportion of the structural unit derived from n-heptyl (meth)acrylate in the (meth)acrylic copolymer is preferably 15% by mass. When the proportion of the structural unit derived from n-heptyl (meth)acrylate is 15% by mass or more, the adhesive composition of the present invention can have higher flexibility and thus can have better filling properties for irregularities and be more easily removable from an irregular surface while preventing or reducing adhesive deposits. Moreover, when the proportion of the structural unit derived from n-heptyl (meth)acrylate containing bio-derived carbon is 15% by mass or more, the adhesive layer of the adhesive tape (described later) can have a higher bio-derived carbon content. The lower limit of the proportion of the structural unit derived from n-heptyl (meth)acrylate is more preferably 35% by mass, still more preferably 50% by mass.

The upper limit of the proportion of the structural unit derived from n-heptyl (meth)acrylate is not limited, but is preferably 98% by mass because the (meth)acrylic copolymer preferably contains a structural unit derived from a monomer containing a polar functional group (described later), a structural unit derived from a functional group-containing unsaturated compound (described later), and/or the like. The upper limit of the proportion of the structural unit derived from n-heptyl (meth)acrylate is more preferably 95% by mass, still more preferably 90% by mass.

The (meth)acrylic copolymer has a carbon-carbon double bond in a side chain.

With the (meth)acrylic copolymer having a carbon-carbon double bond in a side chain, the adhesion of the adhesive composition of the present invention can be greatly decreased upon curing by heating, light irradiation, or the like. The adhesive composition of the present invention thus can be easily removed upon removal, thus exhibiting excellent removability.

The "side chain" herein means a branch structure extending from the main chain of the (meth)acrylic copolymer, where the main chain is the longest chain of the (meth)acrylic copolymer.

The "carbon-carbon double bond" herein excludes carbon-carbon double bonds constituting aromatic rings.

The carbon-carbon double bond can be introduced to the side chain of the (meth)acrylic copolymer by, for example, a method of reacting a (meth)acrylic polymer having no introduced carbon-carbon double bond, obtained by copolymerizing the n-heptyl (meth)acrylate, a polar functional group-containing monomer (described later), and a different monomer (described later), with a compound that contains a functional group reactive with a functional group in the polymer such as a carboxy group or a hydroxy group and contains a carbon-carbon double bond (hereinafter such a compound may also be referred to as a "functional group-containing unsaturated compound").

Examples of the functional group-containing unsaturated compound include the polar functional group-containing monomers described later, depending on the functional group in the (meth)acrylic polymer having no introduced carbon-carbon double bond. For example, when the functional group in the (meth)acrylic polymer having no introduced carbon-carbon double bond is a carboxy group, an epoxy group-containing monomer or an isocyanate group-containing monomer is used, for example. When the functional group in the (meth)acrylic polymer having no introduced carbon-carbon double bond is a hydroxy group, an isocyanate group-containing monomer is used, for example. When the functional group in the (meth)acrylic polymer having no introduced carbon-carbon double bond is an epoxy group, a carboxy group-containing monomer or an amide group-containing monomer (e.g., acrylamide) is used, for example. When the functional group in the (meth)acrylic polymer having no introduced carbon-carbon double bond is an amino group, an epoxy group-containing monomer is used, for example.

Specific examples of the functional group-containing unsaturated compound also include 2-methacryloyloxyethyl isocyanate (MOI), 2-acryloyloxyethyl isocyanate (AOI), and 1,1-(bisacryloyloxymethyl)ethyl isocyanate (BEI).

The lower limit of the proportion of a structural unit derived from the functional group-containing unsaturated compound in the (meth)acrylic copolymer is preferably 0.1% by mass, and the upper limit thereof is preferably 25% by mass. When the proportion of the structural unit derived from the functional group-containing unsaturated compound is 0.1% by mass or more, the adhesive composition of the present invention can be sufficiently cured and thus can have excellent removability. When the proportion of the structural unit derived from the functional group-containing unsaturated compound is 25% by mass or less, the adhesive composition of the present invention can have appropriate flexibility even after curing and can be more easily removed from an irregular surface while preventing or reducing adhesive deposits. The lower limit of the proportion of the structural unit derived from the functional group-containing unsaturated compound is more preferably 0.5% by mass, and the upper limit thereof is more preferably 20% by mass.

The (meth)acrylic copolymer preferably further contains a structural unit derived from a polar functional group-containing monomer. When the (meth)acrylic copolymer contains a structural unit derived from a polar functional group-containing monomer, the adhesive composition of the present invention can have higher cohesion and be more easily removed from an irregular surface while preventing or reducing adhesive deposits. Moreover, in the case where the adhesive composition of the present invention contains a crosslinking agent (described later), reacting the crosslinking agent with the functional group derived from the structural unit derived from a polar functional group-containing monomer by light irradiation, heating, or the like upon removal can decrease the adhesion of the adhesive composition of the present invention, leading to better removability of the adhesive composition of the present invention.

Examples of the structural unit derived from a polar functional group-containing monomer include a structural unit derived from a carboxy group-containing monomer, a structural unit derived from a hydroxy group-containing monomer, a structural unit derived from an epoxy group-containing monomer, a structural unit derived from an isocyanate group-containing monomer, and a structural unit derived from an amino group-containing monomer. In particular, to further improve the cohesion of the adhesive composition, the (meth)acrylic copolymer preferably contains at least one selected from the group consisting of a structural unit derived from a carboxy group-containing monomer and a structural unit derived from a hydroxy group-containing monomer.

Examples of the carboxy group-containing monomer include acrylic acid and methacrylic acid.

Examples of the hydroxy group-containing monomer include hydroxyethyl acrylate and hydroxyethyl methacrylate.

Examples of the epoxy group-containing monomer include glycidyl acrylate and glycidyl methacrylate.

Examples of the isocyanate group-containing monomer include isocyanate ethyl acrylate and isocyanate ethyl methacrylate.

Examples of the amino group-containing monomer include aminoethyl acrylate and aminoethyl methacrylate.

The lower limit of the total proportion of the structural unit derived from a polar functional group-containing monomer in the (meth)acrylic copolymer is preferably 0.01% by mass, and the upper limit thereof is preferably 30% by mass. When the total proportion of the structural unit derived from a polar functional group-containing monomer is 0.01% by mass, the adhesive composition of the present invention can have higher cohesion and be more easily removed from an irregular surface while preventing or reducing adhesive deposits. Moreover, in the case where the adhesive composition of the present invention contains a crosslinking agent (described later), reacting the crosslinking agent with the functional group derived from the structural unit derived from a polar functional group-containing monomer by light irradiation, heating, or the like upon removal can decrease the adhesion of the adhesive composition of the present invention, leading to better removability of the adhesive composition of the present invention. When the total proportion of the structural unit derived from a polar functional group-containing monomer is 30% by mass or less, the adhesive composition of the present invention is not excessively hard, and the adhesive composition of the present invention can have better filling properties for irregularities and sufficient initial adhesion. The lower limit of the total proportion of the structural unit derived from a polar functional group-containing monomer is more preferably 0.1% by mass, and the upper limit thereof is more preferably 28% by mass. The lower limit is still more preferably 1% by mass, and the upper limit is still more preferably 25% by mass.

Each of the polar functional group-containing monomers may be used alone, or two or more of them may be used in combination.

The (meth)acrylic copolymer may contain a structural unit derived from a different monomer other than the structural unit derived from n-heptyl (meth)acrylate or the structural unit derived from a polar functional group-containing monomer.

Examples of the different monomer include alkyl (meth)acrylates other than n-heptyl (meth)acrylate.

Examples of the alkyl (meth)acrylates include methyl (meth)acrylate, ethyl (meth)acrylate, propyl (meth)acrylate, n-butyl (meth)acrylate, tert-butyl (meth)acrylate, 2-ethylhexyl (meth)acrylate, n-octyl (meth)acrylate, isooctyl (meth)acrylate, n-nonyl (meth)acrylate, isononyl (meth)acrylate, decyl (meth)acrylate, isodecyl (meth)acrylate, lauryl (meth)acrylate, myristyl (meth)acrylate, cetyl (meth)acrylate, stearyl (meth)acrylate, isostearyl (meth)acrylate, an ester of 5,7,7-trimethyl-2-(1,3,3-trimethylbutyl)-1-octanol and (meth)acrylic acid, an ester of (meth)acrylic acid and an alcohol having one or two methyl groups in a linear main chain and having a total carbon number of 18, behenyl (meth)acrylate, and arachidyl (meth)acrylate.

Each of these alkyl (meth)acrylates may be used alone, or two or more of them may be in combination.

Examples of the different monomer also include cyclohexyl (meth)acrylate, benzyl (meth)acrylate, 2-butoxyethyl (meth)acrylate, 2-phenoxyethyl (meth)acrylate, tetrahydrofurfuryl (meth)acrylate, and polypropylene glycol mono(meth) acrylate. Examples of the different monomer also include various monomers used for common acrylic polymers, such as vinyl carboxylates (e.g., vinyl acetate) and styrene.

Each of these different monomers may be used alone, or two or more of them may be in combination.

The (meth)acrylic copolymer may be produced by, for example, radically reacting and copolymerizing a monomer mixture containing monomers including the n-heptyl (meth)acrylate and the polar functional group-containing monomer in the presence of a polymerization initiator, and then reacting the resulting (meth)acrylic polymer having no introduced carbon-carbon double bond with the functional group-containing unsaturated compound.

The method for radically reacting the monomer mixture, that is, the polymerization method, is for example a conventionally known method such as solution polymerization (boiling point polymerization or constant temperature polymerization), emulsion polymerization, suspension polymerization, or bulk polymerization.

Examples of the polymerization initiator used for producing the (meth)acrylic copolymer include organic peroxides and azo compounds.

Examples of the organic peroxides include 1,1-bis(t-hexylperoxy)-3,3,5-trimethylcyclohexane, t-hexyl peroxypivalate, t-butyl peroxypivalate, 2,5-dimethyl-2,5-bis(2-ethylhexanoylperoxy)hexane, t-hexyl peroxy-2-ethylhexanoate, t-butyl peroxy-2-ethylhexanoate, t-butyl peroxyisobutyrate, t-butyl peroxy-3,5,5-trimethylhexanoate, and t-butyl peroxylaurate.

Examples of the azo compounds include azobisisobutyronitrile and azobiscyclohexanecarbonitrile.

Each of these polymerization initiators may be used alone, or two or more of them may be in combination.

When the mode of the radical reaction is living radical polymerization, examples of the polymerization initiator include organotellurium polymerization initiators. Any organotellurium polymerization initiator usually used in living radical polymerization may be used. Examples thereof include organotellurium compounds and organotelluride compounds. Here, also in living radical polymerization, any of the azo compounds in addition to the organotellurium polymerization initiator may be used as the polymerization initiator for producing the (meth)acrylic copolymer, so as to promote the polymerization rate.

The lower limit of the carbon-carbon double bond equivalent of the (meth)acrylic copolymer is preferably 0.05 meq/g. When the carbon-carbon double bond equivalent of the (meth)acrylic copolymer is 0.05 meq/g or greater, the adhesive composition of the present invention can have better removability. The lower limit of the carbon-carbon double bond equivalent of the (meth)acrylic copolymer is more preferably 0.06 meq/g, still more preferably 0.075 meq/g.

The upper limit of the carbon-carbon double bond equivalent of the (meth)acrylic copolymer is preferably 3.5 meq/g. When the carbon-carbon double bond equivalent of the (meth)acrylic copolymer is 3.5 meq/g or less, the adhesive composition of the present invention can maintain appropriate flexibility even after curing and can be more easily removed from an irregular surface while preventing or reducing adhesive deposits. The upper limit of the carbon-carbon double bond equivalent of the (meth)acrylic copolymer is more preferably 2.0 meq/g.

The "carbon-carbon double bond equivalent of the (meth)acrylic copolymer" herein refers to the milliequivalents (meq/g) of carbon-carbon double bonds per gram of the (meth)acrylic copolymer.

The upper limit of the acid value of the (meth)acrylic copolymer is preferably 10 mg KOH/g. When the acid value of the (meth)acrylic copolymer is 10 mg KOH/g or less, the adhesive composition of the present invention is not excessively hard, and the adhesive composition of the present invention can have better filling properties for irregularities and also sufficient initial adhesion. The upper limit of the acid value of the (meth)acrylic copolymer is more preferably 9 mg KOH/g, still more preferably 8 mg KOH/g.

The lower limit of the acid value of the (meth)acrylic copolymer is not limited and may be 0 mg KOH/g.

The acid value is an index of the carboxy group content in a certain amount of a sample. The hydroxy value of the (meth)acrylic copolymer herein refers to the number of milligrams of potassium hydroxide necessary to neutralize acid contained in 1 g of the (meth)acrylic copolymer. The value can be calculated by measurement based on potentiometric titration set forth in JIS K 0070:1992.

The lower limit of the hydroxy value of the (meth)acrylic copolymer is preferably 5 mg KOH/g, and the upper limit thereof is preferably 100 mg KOH/g. When the hydroxy value of the (meth)acrylic copolymer is 5 mg KOH/g or greater, the adhesive composition of the present invention can have higher cohesion and be easily removed from an irregular surface while preventing or reducing adhesive deposits. Moreover, in the case where the adhesive composition of the present invention contains a crosslinking agent (described later), reacting the crosslinking agent with the functional group derived from the structural unit derived from a polar functional group-containing monomer by light irradiation, heating, or the like upon removal can decrease the adhesion of the adhesive composition of the present invention, leading to better removability of the adhesive composition of the present invention. When the hydroxy value of the (meth)acrylic copolymer is 100 mg KOH/g or less, the adhesive composition of the present invention is not excessively hard and can have better filling properties for irregularities and also sufficient initial adhesion. The lower limit of the hydroxy value of the (meth)acrylic copolymer is more preferably 7 mg KOH/g, and the upper limit thereof is more preferably 95 mg KOH/g. The lower limit is still more preferably 9 mg KOH/g, and the upper limit is still more preferably 90 mg KOH/g.

The hydroxy value is an index of the hydroxy group content in a certain amount of a sample. The hydroxy value of the (meth)acrylic copolymer refers to the number of milligrams of potassium hydroxide necessary to neutralize, by neutralization titration, the acetic acid bound to hydroxy groups after acetylation of 1 g of the (meth)acrylic copolymer. The hydroxy value can be calculated by measurement based on potentiometric titration set forth in JIS K 0070:1992.

The lower limit of the weight average molecular weight (Mw) of the (meth)acrylic copolymer is preferably 200,000, and the upper limit thereof is preferably 2,000,000. When the weight average molecular weight (Mw) of the (meth)acrylic copolymer is 200,000 or greater, the adhesive composition of the present invention can have sufficient initial adhesion. When the weight average molecular weight (Mw) of the (meth)acrylic copolymer is 2,000,000 or less, the adhesive composition of the present invention is not excessively hard and can have better filling properties for irregularities and also sufficient initial adhesion. The lower limit of the weight average molecular weight (Mw) of the (meth)acrylic copolymer is more preferably 250,000, and the upper limit thereof is more preferably 1,800,000. The lower limit is still more preferably 300,000, and the upper limit is still more preferably 1,500,000.

The weight average molecular weight of the (meth)acrylic copolymer can be determined in terms of standard polystyrene by gel permeation chromatography (GPC). Specifically, it can be measured using 2690 Separations Module available from Waters Corporation as a measurement device, GPC KF-806L available from Showa Denko K.K. as a column, and ethyl acetate as a solvent under the conditions of a sample flow rate of 1 mL/min and a column temperature of 40°C.

The (meth)acrylic copolymer may have any glass transition temperature (Tg). The upper limit of the glass transition temperature (Tg) is preferably -20°C. When the glass transition temperature (Tg) of the (meth)acrylic copolymer is -20°C or lower, the adhesive layer containing the adhesive composition of the present invention can have improved conformability to irregularities and thus have higher adhesion especially to rough surfaces. The upper limit of the glass transition temperature (Tg) of the (meth)acrylic copolymer is more preferably -30°C, still more preferably -40°C, further preferably -50°C. The lower limit of the glass transition temperature (Tg) of the acrylic copolymer is not limited and is usually -90°C or higher. From the standpoint of preventing adhesive deposits on irregular surfaces, the lower limit is preferably -80°C.

The glass transition temperature (Tg) of the (meth)acrylic copolymer can be measured by differential scanning calorimetry, for example.

The adhesive composition of the present invention preferably further contains a polymerization initiator.

When the adhesive composition of the present invention contains a polymerization initiator, the polymerization initiator reacts with the carbon-carbon double bond in the side chain of the (meth)acrylic copolymer to cure the adhesive composition of the present invention. This decreases the adhesion of the adhesive composition, leading to better removability.

The polymerization initiator may be a photopolymerization initiator or a thermal polymerization initiator. To prevent a rise in adhesion of the adhesive composition of the present invention and outgassing therefrom at high temperature, the adhesive composition of the present invention particularly preferably contains a photopolymerization initiator.

The photopolymerization initiator may be one activated by irradiation with light at a wavelength of 250 to 800 nm. Examples of such a photopolymerization initiator include photoradical polymerization initiators including acetophenone derivative compounds such as methoxyacetophenone and 2,2-dimethoxy-2-phenylacetophenone, benzoin ether compounds such as benzoin propyl ether and benzoin isobutyl ether, ketal derivative compounds such as benzyl dimethyl ketal and acetophenone diethyl ketal, and phosphine oxide derivative compounds such as 2,4,6-trimethylbenzoyl-diphenyl phosphine oxide, bis($\eta$5-cyclopentadienyl)titanocene derivative compounds, benzophenone, Michler's ketone, chlorothioxanthone, dodecylthioxanthone, dimethylthioxanthone, diethylthioxanthone, $\alpha$-hydroxycyclohexyl phenyl ketone, 2-hydroxymethyl phenyl propane, and 2-benzyl-2-(dimethylamino)-4'-morpholinobutyrophenone.

Each of these photopolymerization initiators may be used alone, or two or more of them may be used in combination.

The thermal polymerization initiator may be one that is thermally decomposed and generates active radicals to initiate polymerization and curing. Examples thereof include dicumyl peroxide, di-t-butyl peroxide, t-butyl peroxybenzoate, t-butyl hydroperoxide, benzoyl peroxide, cumene hydroperoxide, diisopropylbenzene hydroperoxide, paramenthane hydroperoxide, di-t-butyl peroxide, and t-butyl peroxy-2-ethylhexanoate.

Each of these thermal polymerization initiators may be used alone, or two or more of them may be used in combination.

The lower limit of the amount of the polymerization initiator is preferably 0.1 parts by mass relative to 100 parts by mass of the (meth)acrylic copolymer. When the amount of the polymerization initiator is 0.1 parts by mass or more, the adhesive composition of the present invention can be sufficiently cured and thus can have better removability. The lower limit of the amount of the polymerization initiator is more preferably 0.5 parts by mass, still more preferably 1 part by mass.

The upper limit of the amount of the polymerization initiator is not limited. From the standpoint of appearance defects caused by precipitation of the polymerization initiator, the upper limit of the amount of the polymerization initiator is preferably 20 parts by mass relative to 100 parts by mass of the (meth)acrylic copolymer. The upper limit is more preferably 15 parts by mass, still more preferably 10 parts by mass.

The adhesive composition of the present invention preferably further contains an inorganic filler.

The inorganic filler contained in the adhesive composition of the present invention further increases the cohesion of the adhesive composition of the present invention. This can prevent separation even when additives with different polarities are added to the (meth)acrylic copolymer, thus making the adhesive composition of the present invention more uniform. Moreover, the inorganic filler greatly improves the tensile strength of the adhesive composition of the present invention. This prevents the adhesive composition from breaking due to stress upon removal even after processing with chemical solutions or processing at high temperature, so that the composition can be more easily removed while preventing or reducing adhesive deposits. Further, the adhesive composition can be more easily removed from an irregular surface while preventing or reducing adhesive deposits, exhibiting better removability.

Examples of the inorganic filler include silica nanofillers such as fumed silica, fused silica, and colloid silica, alumina nanofillers, zirconia fillers, carbon nanofillers, glass fillers, titania fillers, and zinc oxide fillers. Preferred among these are fumed silica fine particles and fused silica fine particles, more preferred are fumed silica fine particles. This is because these fillers have easily controllable moisture contents while having easily adjustable surface hydroxy group contents, and also are available in sufficiently small primary particle sizes that make it easy to adjust the average particle size (described later) of the inorganic filler to an appropriate range.

The lower limit of the average particle size of the inorganic filler is preferably 0.05 $\mu$m, and the upper limit thereof is preferably 3 $\mu$m. When the average particle size of the inorganic filler is within the range, the inorganic filler can finely disperse in the adhesive composition of the present invention, making the adhesive composition more uniform.

The average particle size can be measured by, for example, observing 50 random inorganic filler particles with an electron microscope or an optical microscope and calculating the average of the particle sizes of the inorganic filler particles, or by performing laser diffraction particle size distribution measurement.

The lower limit of the amount of the inorganic filler is preferably 1 part by mass, and the upper limit thereof is preferably 40 parts by mass, relative to 100 parts by mass of the (meth)acrylic copolymer. When the amount of the inorganic filler is within the range, the adhesive composition of the present invention can have higher cohesion and be more easily removed from an irregular surface while preventing or reducing adhesive deposits.

The adhesive composition of the present invention preferably further contains a polyfunctional oligomer or a polyfunctional monomer. The polyfunctional oligomer or polyfunctional monomer contained in the adhesive composition of the present invention allows the adhesive composition to efficiently form a three-dimensional network upon light irradiation or application of heat load, leading to better removability of the adhesive composition of the present invention.

The "polyfunctional oligomer or polyfunctional monomer" herein refers to a compound with a weight average molecular weight of 50,000 or less that contains in the molecule two or more functional groups having a carbon-carbon unsaturated bond. The carbon-carbon unsaturated double bond in the "functional groups having a carbon-carbon unsaturated bond" of the polyfunctional oligomer or polyfunctional monomer excludes carbon-carbon double bonds constituting aromatic rings.

As with the weight average molecular weight of the acrylic copolymer, the weight average molecular weight of the polyfunctional oligomer or polyfunctional monomer can be determined by GPC.

Examples of the functional groups having a carbon-carbon unsaturated bond include vinyl, (meth)acryloyl, allyl, and maleimide groups. Preferred among these is a vinyl group because it has high reaction rate under light or heat.

Examples of the polyfunctional oligomer or polyfunctional monomer include (meth)acrylates containing the functional groups having a carbon-carbon unsaturated bond, (meth)acrylic copolymers in which any of the (meth)acrylates containing the functional groups having a carbon-carbon unsaturated bond is copolymerized (excluding those containing a structural unit derived from n-heptyl (meth)acrylate and a carbon-carbon double bond in a side chain), silicone compounds containing the functional groups having a carbon-carbon unsaturated bond, and fluorine compounds containing the functional groups having a carbon-carbon unsaturated bond.

When the adhesive composition of the present invention contains a (meth)acrylate containing the functional groups having a carbon-carbon unsaturated bond or a (meth)acrylic copolymer in which a (meth)acrylate containing the functional groups having a carbon-carbon unsaturated bond is copolymerized, the adhesive composition of the present invention can have further improved photocurability or thermal curability and better removability.

In the (meth)acrylate containing the functional groups having a carbon-carbon unsaturated bond or the (meth) acrylic copolymer in which a (meth)acrylate containing the functional groups having a carbon-carbon unsaturated bond is copolymerized, the lower limit of the number of functional groups having a carbon-carbon unsaturated bond is preferably 2, and the upper limit thereof is preferably 20 in order for an adhesive layer to more efficiently form a three-dimensional network upon heating or light irradiation.

Examples of the (meth)acrylate containing the functional groups having a carbon-carbon unsaturated bond or the (meth)acrylic copolymer in which a (meth)acrylate containing the functional groups having a carbon-carbon unsaturated bond is copolymerized include trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, 1,4-butylene glycol di(meth)acrylate, 1,6-hexanediol di(meth)acrylate, polyethylene glycol di(meth)acrylate, polypropylene glycol diacrylate, and oligoester acrylates such as EBECRYL 524 and EBECRYL 436 (both available from Daicel-Allnex), urethane acrylates such as UN-5500 and UN-5590 (both available from Negami Chemical Industrial Co., Ltd.) and UA-160TM and UA-122P (both available from Shin-Nakamura Chemical Co., Ltd.), and (meth)acrylic copolymers in which any of the (meth)acrylates is copolymerized.

Each of the (meth)acrylates containing the functional groups having a carbon-carbon unsaturated bond or the (meth)acrylic copolymers in which a (meth)acrylate containing the functional groups having a carbon-carbon unsaturated bond is copolymerized may be used alone, or two or more of them may be used in combination.

When the adhesive composition of the present invention contains a silicone compound containing the functional groups having a carbon-carbon unsaturated bond or a fluorine compound containing the functional groups having a carbon-carbon unsaturated bond, the silicone compound or fluorine compound bleeds out at the interface with an adherend, allowing the adhesive composition to be more easily removed while preventing or reducing adhesive deposits. The adhesive composition of the present invention may contain both the silicone compound containing the functional groups having a carbon-carbon unsaturated bond and the fluorine compound containing the functional groups having a carbon-carbon unsaturated bond.

The silicone compound containing the functional groups having a carbon-carbon unsaturated bond or the fluorine compound containing the functional groups having a carbon-carbon unsaturated bond preferably further contains a functional group crosslinkable with the (meth)acrylic copolymer. When the silicone compound containing the functional groups having a carbon-carbon unsaturated bond or the fluorine compound containing the functional groups having a carbon-carbon unsaturated bond contains a functional group crosslinkable with the (meth)acrylic copolymer, the silicone compound or fluorine compound more efficiently reacts with the (meth)acrylic copolymer upon the use of a crosslinking agent or light irradiation. Thus, the silicone compound or fluorine compound is more easily taken in the (meth)acrylic copolymer and less likely to adhere to and contaminate adherends.

The functional group crosslinkable with the (meth)acrylic copolymer is appropriately selected according to the functional groups contained in the (meth)acrylic copolymer. Examples include carboxy, hydroxy, amide, isocyanate, and epoxy groups.

In the silicone compound containing the functional groups having a carbon-carbon unsaturated bond or the fluorine compound containing the functional groups having a carbon-carbon unsaturated bond, the lower limit of the total number of functional groups having a carbon-carbon unsaturated bond and functional groups crosslinkable with the (meth)acrylic copolymer is preferably 2, and the upper limit thereof is preferably 12. When the total number of functional groups having a carbon-carbon unsaturated bond and functional groups crosslinkable with the (meth)acrylic copolymer is 2 or greater, the silicone compound or fluorine compound is less likely to attach and contaminate adherends. When the total number of functional groups having a carbon-carbon unsaturated bond and functional groups crosslinkable with the (meth)acrylic copolymer is 12 or less, the adhesive composition of the present invention can more efficiently form a three-dimensional network upon light irradiation or heating. The upper limit of the total number of functional groups having a carbon-carbon unsaturated bond and functional groups crosslinkable with the (meth)acrylic copolymer is more preferably 4. The total number of functional groups having a carbon-carbon unsaturated bond and functional groups crosslinkable with the (meth)acrylic copolymer is most preferably 2.

Examples of the silicone compound containing the functional groups having a carbon-carbon unsaturated bond include silicone (meth)acrylates and silicone di(meth)acrylates, and (meth)acrylic copolymers in which any of them is copolymerized (excluding those containing n-heptyl (meth)acrylate as a structural unit and a carbon-carbon double bond in a side chain).

Examples of commercial products of the silicone compound containing the functional groups having a carbon-carbon unsaturated bond include methacryloyl group-containing silicone compounds such as X-22-164, X-22-164AS, X-22-164A, X-22-164B, X-22-164C, X-22-164E, X-22-174DX, X-22-2426, and X-22-2475 (all available from Shin-Etsu Chemical Co., Ltd.), and MAC-SQ TM-100, MACSQSI-20, and MAC-SQ HDM (all available from Toagosei Co., Ltd.), and acryloyl group-containing silicone compounds such as EBECRYL 350 and EBECRYL 1360 (both available from Daicel-Allnex) and AC-SQ TA-100 and AC-SQ SI-20 (both available from Toagosei Co., Ltd.).

Examples of the fluorine compound containing the functional groups having a carbon-carbon unsaturated bond include (meth)acrylic copolymers containing a structural unit derived from a fluoro(meth)acrylate (excluding those containing n-heptyl (meth)acrylate as a structural unit and a carbon-carbon double bond in a side chain).

Examples of the fluoro(meth)acrylate include methyl-2-fluoroacrylate and 2-(perfluorobutyl)ethyl acrylate.

The lower limit of the amount of the polyfunctional oligomer or polyfunctional monomer is preferably 1 part by mass, and the upper limit thereof is preferably 50 parts by mass, relative to 100 parts by mass of the (meth)acrylic copolymer. When the amount of the polyfunctional oligomer or polyfunctional monomer is within the range, the adhesive composition of the present invention can have better removability. The lower limit of the amount of the polyfunctional oligomer or polyfunctional monomer is more preferably 2 parts by mass, and the upper limit thereof is more preferably 40 parts by mass.

The adhesive composition of the present invention preferably further contains a gas generating agent. The gas generating agent contained in the adhesive composition of the present invention can generate gas on the bonding surface upon light irradiation or heating, leading to better removability of the adhesive composition of the present invention.

The gas generating agent is not limited and preferably one that generates gas when exposed to light (e.g., UV light or laser light), heat, electromagnetic waves, electron rays, or the like. To prevent a rise in adhesion of the adhesive composition of the present invention and outgassing therefrom at high temperature, the gas generating agent is preferably one that generates gas when exposed to light. Suitable examples of the gas generating agent include, but not limited to, azo compounds, azide compounds, carboxylic acid compounds, and tetrazole compounds.

Examples of the azo compounds include 2,2'-azobis-(N-butyl-2-methylpropionamide), 2,2'-azobis{2-methyl-N-[1,1-bis(hydroxymethyl)-2-hydroxyethyl]propionamide}, 2,2'-azobis{2-methyl-N-[2-(1-hydroxybutyl)]propionamide}, 2,2'-azobis[2-methyl-N-(2-hydroxyethyl)propionamide], 2-azobis[N-(2-propenyl)-2-methylpropionamide], 2,2'-azobis(N-butyl-2-methylpropionamide), 2,2'-azobis(N-cyclohexyl-2-methylpropionamide), 2,2'-azobis[2-(5-methyl-2-imidazoylin-2-yl)propane]dihydrochloride, 2,2'-azobis[2-(2-imidazoylin-2-yl)propane]dihydrochloride, 2,2'-azobis[2-(2-imidazoylin-2-yl)propane]disulfate dihydrolate, 2,2'-azobis[2-(3,4,5,6-tetrahydropyrimidin-2-yl)propane]dihydrochloride, 2,2'-azobis{2-[1-(2-hydroxyethyl)-2-imidazoylin-2-yl]propane}dihydrochloride, 2,2'-azobis[2-(2-imidazoylin-2-yl)propane], 2,2'-azobis(2-methylpropionamidine)hydrochloride, 2,2'-azobis(2-aminopropane)dihydrochloride, 2,2'-azobis[N-(2-carboxyacyl)-2-methyl-propionamidine], 2,2'-azobis{2-[N-(2-carboxyethyl)amidine]propane}, 2,2'-azobis(2-methylpropionamidoxyme), dimethyl 2,2'-azobis(2-methylpropionate), dimethyl 2,2'-azobisisobutyrate, 4,4'-azobis(4-cyanocarbonic acid), 4,4'-azobis(4-cyanopentanoic acid), and 2,2'-azobis(2,4,4-trimethylpentane).

Examples of the azide compounds include 3-azidomethyl-3-methyloxetane, terephthalazide, p-tert-butylbenzazide, and azide-group containing polymers such as glycidyl azide polymers obtained by ring-opening polymerization of 3-azidomethyl-3-methyloxetane.

Examples of the carboxylic acid compounds include phenylacetic acid, diphenylacetic acid, triphenylacetic acid, and salts thereof.

Examples of the tetrazole compounds include 1H-tetrazole, 5-phenyl-1H-tetrazole, 5,5-azobis-1H-tetrazole, and salts thereof.

The lower limit of the amount of the gas generating agent is preferably 5 parts by mass, and the upper limit thereof is preferably 50 parts by mass, relative to 100 parts by mass of the (meth)acrylic copolymer. When the amount of the gas generating agent is 5 parts by mass or more, the gas generating agent can generate enough gas to remove the adhesive composition of the present invention. When the amount of the gas generating agent is 50 parts by mass or less, the gas generating agent can be more compatible with other components in the adhesive composition of the present invention, and the adhesive composition of the present invention can have sufficient initial adhesion. The lower limit of the amount of the gas generating agent is more preferably 10 parts by mass, and the upper limit thereof is more preferably 30 parts by mass.

The adhesive composition of the present invention preferably further contains a tackifier. The tackifier contained in the adhesive composition of the present invention provides sufficient initial adhesion to the adhesive composition.

Examples of the tackifier include rosin resins, rosin ester resins, hydrogenated rosin resins, hydrogenated rosin ester resins, terpene resins, terpenephenol resins, coumarone indene resins, alicyclic saturated hydrocarbon resins, C5 petroleum resins, C9 petroleum resins, and C5-C9 copolymer petroleum resins.

Each of these tackifiers may be used alone, or two or more of them may be used in combination.

The lower limit of the amount of the tackifier is preferably 5 parts by mass, and the upper limit thereof is preferably 60 parts b mass, relative to 100 parts by mass of the (meth)acrylic copolymer. When the amount of the tackifier is 5 parts by mass or more, the adhesive composition of the present invention can have sufficient initial adhesion. When the amount of the tackifier is 60 parts by mass or less, the adhesive composition of the present invention is not excessively hard and can have better removability.

When the (meth)acrylic copolymer contains the structural unit derived from a polar functional group-containing monomer, the adhesive composition of the present invention preferably contains a crosslinking agent. The crosslinking agent contained in the adhesive composition of the present invention reacts with the polar functional group derived from the structural unit derived from a polar functional group-containing monomer, and thus greatly decrease the adhesion of the adhesive composition. As a result, the adhesive composition of the present invention can have better removability.

Examples of the crosslinking agent include isocyanate crosslinking agents, aziridine crosslinking agents, epoxy crosslinking agents, and metal chelate crosslinking agents. Preferred among these are isocyanate crosslinking agents because they have high reaction rates and can further increase the cohesion of the adhesive composition of the present invention.

The lower limit of the amount of the tackifier is preferably 0.05 parts by mass, and the upper limit thereof is preferably 10 parts by mass, relative to 100 parts by mass of the (meth)acrylic copolymer. When the amount of the crosslinking agent is within the range, the adhesive layer containing the adhesive composition of the present invention in the adhesive tape (described later) can have an appropriately adjusted gel fraction and sufficient initial adhesion.

The adhesive composition of the present invention may further contain known additives such as plasticizers, surfactants, or waxes. Each of the additives may be used alone, or two or more of them may be used in combination.

The adhesive composition of the present invention may be produced by, for example, a method of mixing the (meth)acrylic copolymer and as necessary the polymerization initiator, the inorganic filler, the polyfunctional oligomer or polyfunctional monomer, the gas generating agent, the crosslinking agent, and/or the known additives.

The present invention also encompasses an adhesive tape including an adhesive layer containing the adhesive composition of the present invention.

The adhesive tape of the present invention can achieve both excellent filling properties for irregularities and excellent removability.

The adhesive layer may have any thickness. The lower limit thereof is preferably 5 $\mu$m, and the upper limit thereof is preferably 300 $\mu$m. When the thickness of the adhesive layer is within the range, the adhesive layer can have better flexibility, and the adhesive tape of the present invention can achieve both better filling properties for irregularities and better removability. The lower limit of the thickness of the adhesive layer is more preferably 20 $\mu$m, and the upper limit thereof is more preferably 200 $\mu$m. The lower limit is still more preferably 35 $\mu$m, and the upper limit is still more preferably 150 $\mu$m.

The lower limit of the bio-derived carbon content in the adhesive layer is preferably 10%. When the bio-derived carbon content in the adhesive layer is 10% or more, the adhesive tape of the present invention is excellent in terms of saving petroleum resources or reducing carbon dioxide emissions, and causes even less environmental load. The lower limit of the bio-derived carbon content in the adhesive layer is more preferably 25%, still more preferably 40%.

The upper limit of the bio-derived carbon content in the adhesive layer is not limited and may be 100%.

While bio-derived carbon contains a certain proportion of radioisotope (C-14), petroleum-derived carbon hardly contains C-14. Thus, the bio-derived carbon content can be calculated by measuring the C-14 concentration in the adhesive layer. Specifically, the bio-derived carbon content can be measured in conformity with ASTM D6866-22, a standard widely used in the bioplastics industry.

The lower limit of the gel fraction of the adhesive layer is preferably 10% by mass, and the upper limit thereof is preferably 90% by mass. When the gel fraction of the adhesive layer is 10% by mass or more, the adhesive tape of the present invention can have further improved filling properties for irregularities. When the gel fraction of the adhesive layer is 90% by mass or less, the adhesive composition of the present invention can have sufficient initial adhesion. The lower limit of the gel fraction of the adhesive layer is more preferably 20% by mass, and the upper limit thereof is more preferably 80% by mass. The lower limit is still more preferably 30% by mass, and the upper limit is still more preferably 70% by mass.(())

The gel fraction of the adhesive layer can be measured by the following method.

$W_0$ g of the adhesive layer alone is taken out from the resulting adhesive tape, immersed in 50 mL of ethyl acetate, and shaken using a shaker under the conditions of a temperature of 23°C and 200 rpm for 24 hours. After the shaking, a metal mesh (aperture #200 mesh, $W_1$ (g)) is used to separate ethyl acetate and the adhesive layer swollen with ethyl acetate. The separated adhesive layer is dried at 110°C for one hour. The mass $W_2$ (g) of the adhesive layer including the metal mesh after drying is measured, and the gel fraction (% by mass) of the adhesive layer is calculated using the following formula.

$$\text{Gel fraction (\% by mass)} = 100 \times (W_2 - W_1)/W_0$$

($W_0$: the initial mass of the adhesive layer, $W_1$: the initial mass of the metal mesh, $W_2$: the mass of the adhesive layer including the metal mesh after drying)

The lower limit of the gel fraction of the adhesive layer after heating at 150°C for one hour or after irradiation with light of any of the wavelengths in the range from 280 nm to 405 nm at an accumulated light dose of 1,000 mJ/cm$^2$ or greater (hereinafter also referred to as "the gel fraction of the adhesive layer after curing") is preferably 90% by mass. When the gel fraction of the adhesive layer after curing is 90% by mass or more, the adhesive tape of the present invention can have better removability. The lower limit of the gel fraction of the adhesive layer after curing is more preferably 92% by mass, still more preferably 95% by mass.

The gel fraction of the adhesive layer after curing can be measured by the same method as for the gel fraction of the adhesive layer described above, after curing the adhesive layer by heating at 150°C for one hour or irradiation with light of any of the wavelengths in the range from 280 nm to 405 nm at an accumulated light dose of 1,000 mJ/cm$^2$ or greater.

The upper limit of the shear storage modulus at 23°C of the adhesive layer is preferably $1.2 \times 10^5$ Pa. When the shear storage modulus at 23°C of the adhesive layer is $1.2 \times 10^5$ Pa or less, the adhesive layer is not excessively hard, and the adhesive tape of the present invention can have better filling properties for irregularities. The upper limit of the shear storage modulus at 23°C of the adhesive layer is more preferably $1.1 \times 10^5$ Pa, still more preferably $1.0 \times 10^5$ Pa.

The lower limit of the shear storage modulus at 23°C of the adhesive layer is not limited. For the adhesive tape of the present invention to have sufficient initial adhesion, the lower limit is preferably $0.1 \times 10^5$ Pa, more preferably $0.3 \times 10^5$ Pa.

The shear storage modulus at 23°C of the adhesive layer can be measured by, for example, dynamic viscoelasticity measurement using a viscoelastic spectrometer (e.g., DVA-200, available from IT Keisoku Seigyo Co., Ltd.) under the conditions of a shear direction, a frequency of 10 Hz, a temperature increase rate of 10°C/min, and a temperature range from -50°C to 300°C.

When the thickness of the adhesive layer is less than 200 μm, a plurality of the adhesive layers are stacked to give a measurement adhesive layer with a thickness of 200 μm or greater. Using the resulting measurement adhesive layer, the shear storage modulus measurement is performed as described above.

The lower limit of the tensile storage modulus at 23°C of the adhesive layer after heating at 150°C for one hour or after irradiation with light of any of the wavelengths in the range from 280 nm to 405 nm at an accumulated light dose of 1,000 mJ/cm$^2$ or greater (hereinafter also referred to as "the tensile storage modulus at 23°C of the adhesive layer after curing") is preferably $1.0 \times 10^6$ Pa. When the tensile storage modulus at 23°C of the adhesive layer after curing is $1.0 \times 10^6$ Pa or greater, the adhesive tape of the present invention can have better removability. The lower limit of the tensile storage modulus at 23°C of the adhesive layer after curing is more preferably $5.0 \times 10^6$ Pa, still more preferably $1.0 \times 10^7$ Pa.

The preferable upper limit of the tensile storage modulus at 23°C of the adhesive layer after curing is not limited, but the upper limit is about $4.0 \times 10^7$ Pa.

The tensile storage modulus at 23°C of the adhesive layer after curing can be measured by, for example, dynamic viscoelasticity measurement using a viscoelastic spectrometer (e.g., DVA-200, available from IT Keisoku Seigyo Co., Ltd.) under the conditions of a shear direction, a frequency of 10 Hz, a temperature increase rate of 10°C/min, and a temperature range from -5°C to 300°C, after curing the adhesive layer by heating at 150°C for one hour or irradiation with light of any of the wavelengths in the range from 280 nm to 405 nm at an accumulated light dose of 1,000 mJ/cm$^2$ or greater.

When the thickness of the adhesive layer is less than 400 μm, a plurality of the adhesive layers are stacked to give a measurement adhesive layer with a thickness of 400 μm or greater. Using the resulting measurement adhesive layer, the tensile storage modulus measurement is performed as described above.

Here, when the adhesive tape of the present invention includes a substrate, the substrate is removed from the adhesive tape, and the obtained separate adhesive layer alone is used to prepare the measurement adhesive layers for the measurement of the shear storage modulus at 23°C of the adhesive layer and the tensile storage modulus at 23°C of the adhesive layer after curing. Any method may be used to remove the substrate as long as it does not include treatment using a solvent, treatment involving chemical reaction, treatment at high temperature, or the like to avoid deterioration of the adhesive layer. Specific methods for removing the substrate that can be employed include a method of bonding a plurality of the adhesive layers together and then peeling the substrate layer off from each adhesive layer at an appropriately selected temperature and peel rate, and a method of physically grinding the substrate. Alternatively, the measurement adhesive layer may be prepared using a separately prepared sheet consisting only of the adhesive layer.

Any method may be used to adjust the gel fraction of the adhesive layer, the gel fraction of the adhesive layer after curing, the shear storage modulus at 23°C of the adhesive layer, and the tensile storage modulus at 23°C of the adhesive layer after curing to the above-described ranges. An exemplary method includes adjusting the composition of monomers that constitute the (meth)acrylic copolymer and the weight average molecular weight (Mw), carbon-carbon double bond equivalent, hydroxy value, acid value, and/or the like of the (meth)acrylic copolymer.

The adhesive tape of the present invention may be a non-support tape including no substrate or a support tape including a substrate.

When the adhesive tape of the present invention is a support tape including a substrate, it may be a one-sided adhesive tape including the adhesive layer on one surface of the substrate, or a double-sided adhesive tape including the adhesive layers on both surfaces of the substrate.

The substrate is not limited but is preferably one that transmits light. Examples include sheets of transparent resins such as acrylic, polyolefin, polycarbonate, polyvinyl chloride, ABS, polyethylene terephthalate (PET), polyethylene naphthalate (PEN), nylon, polyurethane, polyamide, polyether, polyketone, and polyetheretherketone, mesh-structure sheets, and porous sheets.

To increase the bio-derived carbon content of the entire adhesive tape, the substrate is preferably a bio-derived substrate.

Examples of the bio-derived substrate include films and nonwoven fabrics containing polyesters (PES) such as plant-derived polyethylene terephthalate (PET), plant-derived polyethylene furanoate (PEF), plant-derived polylactic acid (PLA), plant-derived polytrimethylene terephthalate (PTT), plant-derived polybutylene terephthalate (PBT), and plant-derived polybutylene succinate (PBS). Examples also include films and nonwoven fabrics containing plant-derived polyethylene (PE), plant-derived polypropylene (PP), plant-derived polyurethane (PU), plant-derived triacetylcellulose (TAC), plant-derived cellulose, and plant-derived polyamide (PA).

To use less new petroleum resources and emit less carbon dioxide to reduce the environmental load, the substrate may contain recycled resources. The method for recycling resources may involve, for example, collecting waste of packaging containers, home appliances, automobiles, building materials, or food, or waste generated during production processes, and subjecting the recovered material to washing, decontamination, or thermal or fermentative decomposition for reuse as a raw material. Examples of the substrate containing recycled resources include films and non-woven fabrics containing PET, PBT, PE, PP, PA, or the like made from resin recycled from collected plastic. The collected waste may be burned to utilize the heat energy in production of the substrate or raw materials thereof. Fats and oils contained in the collected waste may be added to petroleum, and the petroleum may be fractionated and refined for use as raw materials.

The substrate may have any thickness. The lower limit thereof is preferably 12 $\mu$m, and the upper limit thereof is preferably 200 $\mu$m. When the thickness of the substrate is within this range, the adhesive tape can have appropriate stiffness and excellent handleability while exhibiting high flexibility to closely fit the shape of an adherend in bonding. The lower limit of the thickness of the substrate is more preferably 25 $\mu$m, and the upper limit is more preferably 125 $\mu$m.

The adhesive tape of the present invention may be produced by any method and may be produced by a conventionally known production method. For example, the double-sided adhesive tape may be produced by the following method.

First, a solution of an adhesive A is prepared by adding a solvent to the (meth)acrylic copolymer and optional materials such as the crosslinking agent. The solution of the adhesive A is applied to a surface of the substrate, and the solvent in the solution is completely removed by drying, whereby an adhesive layer A is formed. Next, a release film is placed on the formed adhesive layer A with the release-treated surface of the release film facing the adhesive layer A.

Then, another release film is provided. A solution of an adhesive B prepared in the same manner as above is applied to the release-treated surface of the release film. The solvent in the solution is completely removed by drying, whereby a laminated film including an adhesive layer B on the surface of the release film is formed. The obtained laminated film is placed on the rear surface of the substrate on which the adhesive layer A has been formed, with the adhesive layer B facing the rear surface of the substrate. Thus, a laminate is produced. The laminate is pressurized using a rubber roller or the like. This can produce a double-sided adhesive tape including adhesive layers on both surfaces of the substrate and release films covering the surfaces of the adhesive layers.

Alternatively, two laminated films may be produced in the same manner as above, and the laminated films may be placed on both surfaces of the substrate such that the adhesive layer of each laminated film faces the substrate. The resulting laminate may be pressurized using a rubber roller or the like. This can produce a double-sided adhesive tape including adhesive layers on both surfaces of the substrate and release films covering the surfaces of the adhesive layers.

The lower limit of the 180° peeling force of the adhesive tape of the present invention for SUS is preferably 0.3 N/25 mm. When the 180° peeling force of the adhesive tape of the present invention for SUS is 0.3 N/25 mm or greater, the adhesive tape of the present invention can have sufficient initial adhesion. The lower limit of the 180° peeling force of the adhesive tape of the present invention for SUS is more preferably 0.5 N/25 mm, still more preferably 1.0 N/25 mm.

The upper limit of the 180° peeling force of the adhesive tape of the present invention for SUS is not limited. From the standpoint of the handleability of the adhesive tape, the upper limit is preferably about 20 N/25 mm.

The 180° peeling force of the adhesive tape of the present invention for SUS can be measured, for example, by a tensile test in conformity with JIS Z 0237 at 23°C, a peel rate of 300 mm/min, and a peel angle of 180°.

The upper limit of the 180° peeling force of the adhesive tape for SUS after heating at 150°C for one hour or after irradiation with light of any of the wavelengths in the range from 280 nm to 405 nm at an accumulated light dose of 1,000 mJ/cm$^2$ or greater (hereinafter also referred to as "the 180° peeling force of the adhesive tape after curing for SUS") is preferably 0.3 N/25 mm. When the 180° peeling force of the adhesive tape after curing for SUS is 0.3 N/25 mm or less, the adhesive tape can have better removability. The upper limit of the 180° peeling force of the adhesive tape after curing for SUS is more preferably 0.25 N/25 mm, still more preferably 0.20 N/25 mm.

The 180° peeling force of the adhesive tape after curing for SUS can be measured by the tensile test as in the measurement of the 180° peeling force of the adhesive tape of the present invention for SUS described above, after curing the adhesive tape of the present invention by heating at 150°C for one hour or irradiation with light of any of the wavelengths in the range from 280 nm to 405 nm at an accumulated light dose of 1,000 mJ/cm$^2$ or greater.

Any method may be used to adjust the 180° peeling force of the adhesive tape of the present invention for SUS and the 180° peeling force of the adhesive tape after curing for SUS to the above-described ranges. An exemplary method includes adjusting the composition of monomers that constitute the (meth)acrylic copolymer and the weight average molecular weight (Mw), carbon-carbon double bond equivalent, hydroxy value, acid value, and/or the like of the (meth)acrylic copolymer.

Since the adhesive tape of the present invention has excellent filling properties for irregularities and excellent removability, the adhesive tape is preferably used for temporarily fixing an object with an irregular surface. It is particularly preferably used for temporarily fixing a semiconductor wafer, more preferably a bump wafer with an irregular surface.

The present invention also encompasses a method for processing a semiconductor wafer, including the step of temporarily fixing a semiconductor wafer to a support using the adhesive tape of the present invention, curing the adhesive layer with light or heat, and then removing the adhesive tape.

The use of the adhesive tape of the present invention in the method for processing a semiconductor wafer of the present invention can improve the processing quality of the electronic component to be produced even when the semiconductor wafer has an irregular surface.

Examples of the support include glass, quartz, sapphire, copper plates, organic substrates, FR4 substrates, and silicon substrates. Supports with high UV transmittance are particularly preferred, and glass, quartz, and sapphire are preferred. When the support has high UV transmittance, in the method for processing a semiconductor wafer of the present invention, the adhesive tape of the present invention can be more easily removed by irradiating the adhesive tape with laser light or UV light from the substrate side and removing the support before removing the cured adhesive tape of the present invention from the semiconductor wafer.

In the processing method of the present invention, curing of the adhesive layer with light may be performed by, for example, a method of irradiating with light of any of the wavelengths in the range from 280 nm to 405 nm at an accumulated light dose of 1,000 mJ/cm$^2$ or greater.

Curing of the adhesive tape with heat may be performed by, for example, a method of heating at a temperature of 100°C or higher and 200°C or lower for 10 minutes or longer and 2 hours or shorter.

The semiconductor wafer used in the method for processing a semiconductor wafer of the present invention is not limited. The method for processing a semiconductor wafer of the present invention is applicable to processing of all the semiconductor wafers used in usual electronic components. The method for processing a semiconductor wafer of the present invention prevents or reduces peeling of the adhesive tape even from a semiconductor wafer with surface irregularities, such as one provided with electrodes or circuits, in washing, thinning, dicing, and other steps and allows easy removal of the adhesive tape from the semiconductor wafer surface after curing of the adhesive tape, while preventing or reducing adhesive deposits.

The present invention also encompasses a method for producing a semiconductor device, including the step of temporarily fixing a semiconductor wafer to a support using the adhesive tape according to the present invention, curing the adhesive layer with light or heat, and then removing the adhesive tape.

The method for producing a semiconductor device of the present invention can improve the processing quality of the semiconductor device to be produced even when it has an irregular surface, and thereby improve the production yield, resulting in improved semiconductor device production efficiency.

The method for producing a semiconductor device of the present invention can be used in, for example, film forming, etching, washing, thinning, cutting, bumping, reflow, annealing, ashing, and other semiconductor device production steps.

- Advantageous Effects of Invention

The present invention can provide an adhesive composition that can achieve both excellent filling properties for irregularities and excellent removability. The present invention can also provide an adhesive tape including an adhesive layer containing the adhesive composition. The present invention can also provide a method for processing a semiconductor wafer using the adhesive tape and a method for producing a semiconductor device using the adhesive tape.

DESCRIPTION OF EMBODIMENTS

The embodiments of the present invention are more specifically described in the following with reference to examples. These examples are not intended to limit the present invention.

<n-Heptyl acrylate containing bio-derived carbon>

Castor oil-derived ricinoleic acid was cracked into a mixture containing undecylenic acid and heptyl alcohol. Subsequently, heptyl alcohol was separated from undecylenic acid by distillation, whereby n-heptyl alcohol containing bio-derived carbon was obtained. The n-heptyl alcohol containing bio-derived carbon was esterified with acrylic acid (available from Nippon Shokubai Co., Ltd.) to prepare n-heptyl acrylate containing bio-derived carbon.

(Example 1)

(1) Preparation of (meth)acrylic copolymer

A reactor equipped with a thermometer, a stirrer, and a condenser was charged with 78.2 parts by mass of n-heptyl acrylate containing bio-derived carbon, prepared as above, as alkyl (meth)acrylate, 19.8 parts by mass of 2-hydroxyethyl acrylate as a functional group-containing monomer, 1.0 parts by mass of acrylic acid, and 80 parts by mass of ethyl acetate. The reactor was then heated to initiate reflux. To the reactor was subsequently added 0.01 parts by mass of 1,1-bis(t-hexylperoxy)-3,3,5-trimethylcyclohexane as a polymerization initiator to initiate polymerization under reflux. Then, 1,1-bis(t-hexylperoxy)-3,3,5-trimethylcyclohexane was added one hour after and two hours after the start of the polymerization (0.01 part by mass each time). Four hours after the start of the polymerization, 0.05 parts by mass of t-hexyl peroxypivalate was added to continue the polymerization reaction. Eight hours after the start of the polymerization, ethyl acetate was added to the reactor and the contents of the reactor were cooled while diluting, whereby a solution of a (meth) acrylic polymer having no introduced carbon-carbon double bond in ethyl acetate was obtained. To the obtained solution of the (meth)acrylic polymer having no introduced carbon-carbon double bond in ethyl acetate was added 1.0 parts by mass of 2-isocyanatoethyl methacrylate as a functional group-containing unsaturated compound. The mixture was reacted to give a solution of a (meth)acrylic copolymer A (hydroxy value 90 mg KOH/g, acid value 7.0 mg KOH/g, carbon-carbon double bond equivalent 0.075 meq/g).

The hydroxy value and acid value of the (meth)acrylic copolymer A were measured in conformity with potentiometric titration set forth in JIS K 0070:1992.

The obtained (meth)acrylic copolymer A had a weight average molecular weight of 900,000 as measured using 2690 Separations Module available from Waters Corporation as a measurement device, GPC KF-806L available from Showa Denko K.K. as a column, and ethyl acetate as a solvent under the conditions of a sample flow rate of 1 mL/min and a column temperature of 40°C.

(2) Production of adhesive composition and adhesive tape

To the obtained solution of the (meth)acrylic copolymer A was added 0.2 parts by mass of an isocyanate crosslinking agent (Coronate L-45K, available from Soken Chemical & Engineering Co., Ltd.) and 1.0 parts by mass of a photopolymerization initiator (Omnirad 369E, available from IGM resins) relative to 100 parts by mass of the (meth)acrylic copolymer, whereby a solution of an adhesive composition in ethyl acetate was prepared.

The obtained solution of the adhesive composition in ethyl acetate was applied with a doctor knife to the release-treated surface of a 50-μm-thick release-treated polyethylene terephthalate (PET) film such that the thickness of the adhesive layer after drying would be 30 μm. The applied solution was then dried at 110°C for five minutes to form an adhesive layer. Subsequently, the obtained adhesive layer was attached to a 25-μm-thick substrate of polyethylene naphthalate (PEN) film and left to stand at 40°C for five days for aging, whereby an adhesive tape with the adhesive layer on one side of the substrate was obtained.

(3) Bio-derived carbon content in adhesive layer

The bio-derived carbon content in the obtained adhesive layer was measured in conformity with ASTM D6866-22. Table 2 shows the results.

(4) Measurement of gel fraction of adhesive layer

The obtained solution of the adhesive composition in ethyl acetate was applied with a doctor knife to the release-treated surface of a 50-μm-thick release-treated polyethylene terephthalate (PET) film such that the thickness of the adhesive layer after drying would be 30 μm. The obtained adhesive layer was attached to the release-treated surface of a 50-μm-thick release-treated polyethylene terephthalate (PET) film and left to stand at 40°C for five days for aging, whereby an adhesive tape for gel fraction measurement was obtained. The obtained adhesive tape for gel fraction measurement was cut into a size of 5 cm long and 5 cm wide to give an evaluation sample.

$W_0$ g of the adhesive layer alone was taken out from the obtained evaluation sample, immersed in 50 mL of ethyl acetate, and shaken using a shaker under the conditions of a temperature of 23°C and 200 rpm for 24 hours. After the shaking, a metal mesh (aperture #200 mesh, $W_1$ (g)) was used to separate ethyl acetate and the adhesive layer swollen with ethyl acetate. The separated adhesive layer was dried at 110°C for one hour. The mass $W_2$ (g) of the adhesive layer including the metal mesh after drying was measured, and the gel fraction (% by mass) of the adhesive layer was calculated using the following formula. Table 2 shows the results.

$$\text{Gel fraction (\% by mass)} = 100 \times (W_2 - W_1)/W_0$$

($W_0$: the initial mass of the adhesive layer, $W_1$: the initial mass of the metal mesh, $W_2$: the mass of the adhesive layer including the metal mesh after drying)

(5) Measurement of gel fraction of adhesive layer after curing

An adhesive tape for gel fraction measurement obtained as in (4) Measurement of gel fraction of adhesive layer described above was cut into a size of 5 cm long and 5 cm wide. The adhesive layer was then cured by irradiation with light of a wavelength of 405 nm at accumulated light amount of 2,500 mJ/cm$^2$ using an ultra-high pressure mercury lamp, whereby an evaluation sample was prepared.

The gel fraction (% by mass) of the obtained evaluation sample was measured as in (4) Measurement of gel fraction of adhesive layer described above, whereby the gel fraction (% by mass) of the adhesive layer after curing was obtained. Table 2 shows the results.

(6) Measurement of shear storage modulus at 23°C of adhesive layer

The obtained solution of the adhesive composition in ethyl acetate was applied with a doctor knife to the release-treated surface of a 50-$\mu$m-thick release-treated polyethylene terephthalate (PET) film such that the thickness of the adhesive layer after drying would be 50 $\mu$m. The obtained adhesive layer was attached to the release-treated surface of a 50-$\mu$m-thick release-treated polyethylene terephthalate (PET) film and left to stand at 40°C for five days for aging, whereby an adhesive tape for shear storage modulus measurement was obtained. A plurality of adhesive layers were prepared from the obtained adhesive tape for shear storage modulus measurement and stacked to a thickness of 400 $\mu$m or greater to give an evaluation sample.

A dynamic viscoelastic spectrum of the evaluation sample was measured using a viscoelastic spectrometer (DVA-200, available from IT Keisoku Seigyo Co., Ltd.) under the conditions of a shear direction, a temperature increase rate of 10°C/min in a simple temperature increase mode, a frequency of 10 Hz, and a temperature range from -50°C to 300°C. Thus, the shear storage modulus (Pa) at 23°C of the adhesive layer was determined. Table 2 shows the results.

(7) Measurement of tensile storage modulus at 23°C of adhesive layer after curing

An adhesive tape for shear storage modulus was obtained as in (6) Measurement of shear storage modulus at 23°C of adhesive layer described above. A plurality of adhesive layers were prepared from the obtained adhesive tape, stacked to a thickness of 400 $\mu$m or greater, and then cured by irradiation with light of a wavelength of 405 nm at accumulated light amount of 2,500 mJ/cm$^2$ using a ultra-high pressure mercury lamp, whereby an evaluation sample was prepared.

A dynamic viscoelastic spectrum of the obtained evaluation sample was measured using a viscoelastic spectrometer (DVA-200, available from IT Keisoku Seigyo Co., Ltd.) under the conditions of a tensile direction, a temperature increase rate of 10°C/min in a simple temperature increase mode, a frequency of 10 Hz, and a temperature range from -50°C to 300°C. Thus, the tensile storage modulus (Pa) at 23°C of the adhesive layer after curing was determined. Table 2 shows the results.

(8) Measurement of 180° peeling force of adhesive tape for SUS

The adhesive tape obtained in (2) Production of adhesive composition and adhesive tape described above was cut into a flat, rectangular shape (25 mm wide × 100 mm long) and attached to a SUS plate (SUS304 plate, washed with ethanol and then wiped dry) by moving a 2-kg rubber roller thereon back and forth once at 300 mm/min. The adhesive tape was aged at 23°C and 50% RH for 20 minutes to give a test sample. The obtained test sample was subjected to a tensile test in conformity with JIS Z 0237 at 23°C, 50% RH, a tensile rate of 300 mm/min, and a peel angle of 180°, whereby the 180° peeling force (N/25 mm) of the adhesive tape for SUS was measured. Table 2 shows the results.

(9) Measurement of 180° peeling force of adhesive tape after curing for SUS

As in (8) Measurement of 180° peeling force of adhesive tape described above, the adhesive tape obtained in (2) Production of adhesive composition and adhesive tape described above was attached to a SUS plate (SUS304 plate, washed with ethanol and then wiped dry) and then aged at 23°C and 50% RH for 20 minutes. The adhesive tape attached to the SUS plate was cured by irradiation with light of a wavelength of 405 nm at accumulated light amount of 2,500 mJ/cm$^2$ using an ultra-high pressure mercury lamp, whereby a test sample was prepared. The obtained test sample was subjected to a tensile test in conformity with JIS Z 0237 at 23°C, 50% RH, a tensile rate of 300 mm/min, and a peel angle of 180°, whereby the 180° peeling force (N/25 mm) of the adhesive tape after curing for SUS was measured. Table 2 shows the results.

<Evaluation>

The adhesive tape obtained in (2) Production of adhesive composition and adhesive tape described above was evaluated as follows. Table 2 shows the results.

(1) Irregularities-filling properties

The obtained adhesive tape was cut into a circular shape with a diameter of 20 cm. A silicon wafer with a diameter of 20 cm and a thickness of about 750 μm and with steps about 10 μm high was prepared. The adhesive tape was attached to the stepped side of the wafer in vacuum and then left to stand at 23°C and 50% RH for one hour, whereby a measurement sample was prepared. The stepped silicon wafer was prepared by making cuts (about 10 μm) in a surface of a wafer (Φ 8 inch, thickness 725 μm) using a dicing device (DFD6360, available from DISCO Corporation).

The wafer surface of the measurement sample was observed using an optical microscope (VHX-970F, available from Keyence Corporation, magnification 10x), and the filling properties for irregularities (irregularities-filling properties) of the adhesive tape were evaluated in accordance with the following criteria.

· ∞: No gap was found between the wafer and the adhesive tape.
· ○: The size of the gap between the wafer and the adhesive was less than 5% of the entire area of the bonding surface.
· ×: The size of the gap between the wafer and the adhesive tape was at least 5% of the entire area of the bonding surface.

(2) Removability

(2-1) Residue

The adhesive tape of the measurement sample used in the evaluation of Irregularities-filling properties described above was cured by irradiation with light of a wavelength of 405 nm at accumulated light amount of 2,500 mJ/cm². The cured adhesive tape was removed from the stepped silicon wafer using a tape for tape removal. The surface of the stepped silicon wafer after the adhesive tape was removed therefrom was observed using an optical microscope (VHX-970F, available from Keyence Corporation, magnification 10x). The residue was evaluated in accordance with the following criteria, and the removability of the adhesive tape was determined.

· ∞: No residue was present on the wafer surface.
· ○: Residue was present on less than 5% of the entire area of the bonding surface on the wafer surface.
· ×: Residue was present on at least 5% of the entire area of the bonding surface on the wafer surface.

(2-2) Wafer cracking

The obtained adhesive tape was cut into a circular shape with a diameter of 20 cm. A stepped silicon wafer with a diameter of 20 cm, a thickness of about 750 μm, and steps of circuits (irregularities) about 10 μm high was prepared as in the evaluation of Irregularities-filling properties described above. The adhesive tape was attached to the stepped side of the stepped wafer in vacuum. The non-stepped side of the stepped silicon wafer with the adhesive tape was ground and polished to reduce the thickness of the stepped silicon wafer to 50 μm, whereby a measurement sample was prepared.

The adhesive tape of the obtained measurement sample was cured by irradiation with light of a wavelength of 405 nm at accumulated light amount of 2,500 mJ/cm². The cured adhesive tape was removed from the stepped silicon wafer using a tape for tape removal. The stepped silicon wafer after the adhesive tape was removed therefrom was visually examined for wafer cracking. The same process was performed on five measurement samples. The removability of the adhesive tape was evaluated in accordance with the following criteria.

· ∞: None of the five stepped silicon wafers cracked.
· ○: One of the five stepped silicon wafers cracked.
· ×: Two or more of the five stepped silicon wafers cracked.

(Examples 2 to 12 and 14 to 17 and Comparative Examples 1 to 5)

A (meth)acrylic copolymer, an adhesive composition, and an adhesive tape were prepared as in Example 1 except that in (1) Preparation of (meth)acrylic copolymer described above, the composition of the (meth)acrylic copolymer was changed as shown in Table 1, and in (2) Production of adhesive composition and adhesive tape described above, the composition of the adhesive composition was changed as shown in Tables 2 to 4. The (meth)acrylic copolymer, adhesive layer, and adhesive tape were measured and evaluated as in Example 1. Tables 1 to 4 show the results.

(Example 13)

A (meth)acrylic copolymer, an adhesive composition, and an adhesive tape were prepared as in Example 1 except that in (1) Preparation of (meth)acrylic copolymer described above, the composition of the (meth)acrylic copolymer was changed as shown in Table 1, and in (2) Production of adhesive composition and adhesive tape described above, the composition of the adhesive composition was changed as shown in Table 3 and the substrate was changed from the 25-μm-thick PEN film to a 25-μm-thick PET film. The (meth)acrylic copolymer, adhesive layer, and adhesive tape were measured and evaluated as in Example 1. Tables 1 and 3 show the results.

(Example 18)

In (1) Preparation of (meth)acrylic copolymer described above, the composition of the (meth)acrylic copolymer was changed as shown in Table 1, and in (2) Production of adhesive composition and adhesive tape described above, the composition of the adhesive composition was changed as shown in Tables 3. In the measurements and evaluations of (5) Measurement of gel fraction of adhesive layer after curing, (7) Measurement of tensile storage modulus at 23°C of adhesive layer after curing, (9) Measurement of 180° peeling force of adhesive tape after curing for SUS, (2-1) Residue, and (2-2) Wafer cracking described above, the adhesive layer was cured by heating at 150°C for 10 minutes instead of irradiation with light of a wavelength of 405 nm at accumulated light amount of 2,500 mJ/cm$^2$ using an ultra-high pressure mercury lamp. Except for these changes, a (meth)acrylic copolymer, an adhesive composition, and an adhesive tape were prepared as in Example 1, and the (meth)acrylic copolymer, the adhesive layer, and the adhesive tape were measured and evaluated as in Example 1. Tables 1 and 3 show the results.

The abbreviations of materials in Table 1 refer to the following compounds.

· HPA: n-heptyl acrylate
· 2-EHA: 2-ethylhexyl acrylate
· BA: n-butyl acrylate
· HEA: 2-hydroxyethyl acrylate
· AAc: acrylic acid
· MOI: 2-isocyanatoethyl methacrylate

The abbreviations of substrates in Tables 2 to 4 refer to the following compounds.

· PEN: polyethylene naphthalate
· PET: polyethylene terephthalate

[Table 1]

| Composition (% by mass) | | | | | (Meth)acrylic copolymer | | | | | | | | | | | | | | | |
|---|---|---|---|---|---|---|---|---|---|---|---|---|---|---|---|---|---|---|---|---|
| | | | | | A | B | C | D | E | F | G | H | I | J | K | L | M | N | O | P |
| | Contain bio-derived carbon | (Meth)acrylic polymer having no introduced carbon–carbon double bond | Alkyl (meth)acrylate | HPA | 78.2 | 73.2 | 67.0 | 47.0 | 73.2 | 80.6 | 73.8 | 54.9 | 36.6 | 29.3 | 18.3 | 79.0 | - | - | - | - |
| | Not contain bio-derived carbon | | | 2-EHA | - | - | - | - | - | - | - | 18.3 | 36.6 | 43.9 | 54.9 | - | 73.2 | - | 79.0 | - |
| | | | | BA | - | - | - | - | - | - | - | - | - | - | - | - | - | 73.2 | - | 79.0 |
| | | | Hydroxy group-containing monomer | HEA | 19.8 | 18.5 | 16.9 | 26.8 | 18.5 | 10.2 | 18.7 | 18.5 | 18.5 | 18.5 | 18.5 | 20.0 | 18.5 | 18.5 | 20.0 | 20.0 |
| | | | Carboxy group-containing monomer | AAc | 1.0 | 0.9 | 0.8 | 0.6 | 0.9 | 1.0 | - | 0.9 | 0.9 | 0.9 | 0.9 | 1.0 | 0.9 | 0.9 | 1.0 | 1.0 |
| | | Functional group-containing unsaturated compound | | MOI | 1.0 | 7.4 | 15.3 | 25.6 | 7.4 | 8.2 | 7.5 | 7.4 | 7.4 | 7.4 | 7.4 | - | 7.4 | 7.4 | - | - |
| Carbon–carbon double bond equivalent of (meth)acrylic copolymer (meq/g) | | | | | 0.075 | 0.6 | 1.4 | 3.2 | 0.6 | 0.6 | 0.6 | 0.6 | 0.6 | 0.6 | 0.6 | 0 | 0.6 | 0.6 | 0 | 0 |
| Weight average molecular weight of (meth)acrylic copolymer Mw | | | | | 900000 | 900000 | 900000 | 900000 | 300000 | 900000 | 900000 | 960000 | 840000 | 900000 | 900000 | 900000 | 800000 | 1000000 | 800000 | 1000000 |
| Hydroxy value of (meth)acrylic copolymer (mg KOH/g) | | | | | 90 | 60 | 10 | 10 | 60 | 10 | 60 | 60 | 60 | 60 | 60 | 60 | 60 | 60 | 60 | 60 |
| Acid value of (meth)acrylic copolymer (mg KOH/g) | | | | | 7 | 7 | 7 | 7 | 7 | 7 | 0 | 7 | 7 | 7 | 7 | 7 | 7 | 7 | 7 | 7 |

[Table 2]

| | | | Example 1 | Example 2 | Example 3 | Example 4 | Example 5 | Example 6 | Example 7 | Example 8 | Example 9 |
|---|---|---|---|---|---|---|---|---|---|---|---|
| Adhesive composition | (Meth)acrylic copolymer | Type | A | B | C | D | E | F | G | B | B |
| | | Parts by mass | 100 | 100 | 100 | 100 | 100 | 100 | 100 | 100 | 100 |
| | Photopolymerization initiator (parts by mass) | 2-Benzyl-2-(dimethylamino)-4'-morpholinobutyrophenone (Omnirad 369E, available from IGM Resins) | 1 | 1 | 1 | 1 | 1 | 1 | 1 | - | 1 |
| | | 2,4,6-Trimethylbenzoyl-diphenyl phosphine oxide (Ominrad TPO, available from IGM Resins) | - | - | - | - | - | - | - | 1 | - |
| | | 2,2-Dimethoxy-2-phenylacetophenone (Omnirad 651, available from IGM Resins) | - | - | - | - | - | - | - | - | - |
| | Thermal polymerization initiator (parts by mass) | t-Butyl peroxy-2-ethylhexanoate (Perbutyl O, available from NOF Corporation) | - | - | - | - | - | - | - | - | - |
| | Inorganic filler (parts by mass) | Fumed silica (MT-10, available from Tokuyama Corporation) | - | - | - | - | - | - | - | - | 10 |
| | Polyfunctional oligomer (parts by mass) | Silicone compound (EBECRYL 350, available from Daicel-Allnex) | - | - | - | - | - | - | - | - | - |
| | Gas generating agent (parts by mass) | 2,2'-Azobis(N-butyl-2-methylpropionamide) (Vam-110, available from FUJIFILM Wako Pure Chemical Corporation) | - | - | - | - | - | - | - | - | - |
| | Tackifier (parts by mass) | Hydrogenated rosin ester resin (KE-100, available from Arakawa Chemical Industries Ltd.) | - | - | - | - | - | - | - | - | - |

(continued)

| | | Example 1 | Example 2 | Example 3 | Example 4 | Example 5 | Example 6 | Example 7 | Example 8 | Example 9 |
|---|---|---|---|---|---|---|---|---|---|---|
| Crosslinking agent (parts by mass) | Isocyanate crosslinking agent (Coronate L-45K, available from Soken Chemical & Engineering Co.,Ltd.) | 0.2 | 0.2 | 0.2 | 0.2 | 0.2 | 0.2 | 0.2 | 0.2 | 0.2 |
| Substrate material | | PEN | PEN | PEN | PEN | PEN | PEN | PEN | PEN | PEN |
| Bio-derived carbon content in adhesive layer (%) | | 57 | 54 | 51 | 38 | 54 | 59 | 55 | 54 | 54 |
| Gel fraction of adhesive layer (% by mass) | | 60 | 68 | 60 | 59 | 60 | 30 | 45 | 68 | 72 |
| Gel fraction of adhesive layer after curing (% by mass) | | 95 | 99 | 98 | 99 | 98 | 98 | 98 | 99 | 99 |
| Shear storage modulus at 23°C of adhesive layer ($\times 10^5$ Pa) | | 0.60 | 0.56 | 0.60 | 0.59 | 0.10 | 0.60 | 0.30 | 0.56 | 1.12 |
| Tensile storage modulus at 23°C of adhesive layer after curing ($\times 10^6$ Pa) | | 1.5 | 15.6 | 36.0 | 42.2 | 13.5 | 15.0 | 15.0 | 15.6 | 24.7 |
| 180° Peeling force of adhesive tape for SUS (N/25 mm) | | 6.0 | 5.9 | 6.0 | 6.0 | 10.0 | 10.0 | 5.0 | 5.9 | 6.9 |
| 180° Peeling force of adhesive tape after curing for SUS (N/25 mm) | | 0.20 | 0.11 | 0.07 | 0.07 | 0.15 | 0.11 | 0.11 | 0.11 | 0.09 |
| Evaluation | Irregularities-filling properties | ○○ | ○○ | ○○ | ○○ | ○○ | ○○ | ○○ | ○○ | ○ |
| Evaluation | Removability — Residue | ○ | ○○ | ○ | ○ | ○○ | ○○ | ○○ | ○○ | ○○ |
| Evaluation | Removability — Wafer cracking | ○ | ○ | ○ | ○ | ○ | ○ | ○ | ○ | ○ |

[Table 3]

| | | | Example 10 | Example 11 | Example 12 | Example 13 | Example 14 | Example 15 | Example 16 | Example 17 | Example 18 |
|---|---|---|---|---|---|---|---|---|---|---|---|
| Adhesive composition | (Meth)acrylic copolymer | Type | B | B | B | B | H | I | J | K | B |
| | | Parts by mass | 100 | 100 | 100 | 100 | 100 | 100 | 100 | 100 | 100 |
| | Photopolymerization initiator (parts by mass) | 2-Benzyl-2-(dimethylamino)-4'-morpholi nobutyrophenone (Omnirad 369E, available from IGM Resins) | 1 | 1 | 1 | - | 1 | 1 | 1 | 1 | - |
| | | 2,4,6-Trimethylbenzoyl-diphenyl phosphine oxide (Ominrad TPO, available from IGM Resins) | - | - | - | - | - | - | - | - | - |
| | | 2,2-Dimethoxy-2-phenylacetophenone (Omnirad 651, available from IGM Resins) | - | - | - | 1 | - | - | - | - | - |
| | Thermal polymerization initiator (parts by mass) | t-Butyl peroxy-2-ethylhexanoate (Perbutyl O, available from NOF Corporation) | - | - | - | - | - | - | - | - | 5 |
| | Inorganic filler (parts by mass) | Fumed silica (MT-10, available from Tokuyama Corporation) | - | - | - | - | - | - | - | - | - |
| | Polyfunctional oligomer (parts by mass) | Silicone compound (EBECRYL 350, available from Daicel-Allnex) | 10 | - | - | - | - | - | - | - | - |
| | Gas generating agent (parts by mass) | 2,2'-Azobis(N-butyl-2-methylpropionamide) (Vam-110, available from FUJIFILM Wako Pure Chemical Corporation) | - | 10 | - | - | - | - | - | - | - |
| | Tackifier (parts by mass) | Hydrogenated rosin ester resin (KE-100, available from Arakawa Chemical Industries Ltd.) | - | - | 10 | - | - | - | - | - | - |

(continued)

| | | | Example 10 | Example 11 | Example 12 | Example 13 | Example 14 | Example 15 | Example 16 | Example 17 | Example 18 |
|---|---|---|---|---|---|---|---|---|---|---|---|
| | Crosslinking agent (parts by mass) | Isocyanate crosslinking agent (Coronate L-45K, available from Soken Chemical & Engineering Co.,Ltd.) | 0.2 | 0.2 | 0.2 | 0.2 | 0.2 | 0.2 | 0.2 | 0.2 | 0.2 |
| Substrate material | | | PEN | PEN | PEN | PET | PEN | PEN | PEN | PEN | PEN |
| Bio-derived carbon content in adhesive layer (%) | | | 53 | 55 | 62 | 56 | 43 | 29 | 23 | 14 | 53 |
| Gel fraction of adhesive layer (% by mass) | | | 63 | 61 | 62 | 68 | 69 | 66 | 66 | 66 | 65 |
| Gel fraction of adhesive layer after curing (% by mass) | | | 98 | 93 | 92 | 99 | 98 | 99 | 99 | 99 | 98 |
| Shear storage modulus at 23°C of adhesive layer ($\times 10^5$ Pa) | | | 0.38 | 0.42 | 0.47 | 0.50 | 0.61 | 0.64 | 0.71 | 0.75 | 0.56 |
| Tensile storage modulus at 23°C of adhesive layer after curing ($\times 10^6$ Pa) | | | 11.1 | 10.4 | 11.9 | 13.6 | 19.2 | 18.3 | 20.1 | 21.0 | 14.5 |
| 180° Peeling force of adhesive tape for SUS (N/25 mm) | | | 1.3 | 3.9 | 7.7 | 6.5 | 6.2 | 7.3 | 7.5 | 7.9 | 5.9 |
| 180° Peeling force of adhesive tape after curing for SUS (N/25 mm) | | | 0.07 | 0.04 | 0.14 | 0.10 | 0.11 | 0.11 | 0.11 | 0.11 | 0.18 |
| Evaluation | Irregularities-filling properties | | ○○ | ○○ | ○○ | ○○ | ○○ | ○○ | ○○ | ○○ | ○○ |
| | Removability | Residue | ○○ | ○○ | ○○ | ○○ | ○○ | ○○ | ○ | ○ | ○○ |
| | | Wafer cracking | ○○ | ○○ | ○ | ○ | ○ | ○ | ○ | ○ | ○ |

[Table 4]

| Adhesive composition | | | Comparative Example 1 | Comparative Example 2 | Comparative Example 3 | Comparative Example 4 | Comparative Example 5 |
|---|---|---|---|---|---|---|---|
| | (Meth)acrylic copolymer | Type | L | M | N | ○ | P |
| | | Parts by mass | 100 | 100 | 100 | 100 | 100 |
| | Photopolymerization initiator (parts by mass) | 2-Benzyl-2-(dimethylamino)-4'-morpholinobutyrophenone (Omnirad 369E, available from IGM Resins) | - | 1 | 1 | - | - |
| | | 2,4,6-Trimethylbenzoyl-diphenyl phosphine oxide (Ominrad TPO, available from IGM Resins) | - | - | - | - | - |
| | | 2,2-Dimethoxy-2-phenylacetophenone (Omnirad 651, available from IGM Resins) | - | - | - | - | - |
| | Thermal polymerization initiator (parts by mass) | t-Butyl peroxy-2-ethylhexanoate (Perbutyl O, available from NOF Corporation) | - | - | - | - | - |
| | Inorganic filler (parts by mass) | Fumed silica (MT-10, available from Tokuyama Corporation) | - | - | - | - | - |
| | Polyfunctional oligomer (parts by mass) | Silicone compound (EBECRYL 350, available from Daicel-Allnex) | - | - | - | - | - |
| | Gas generating agent (parts by mass) | 2,2'-Azobis(N-butyl-2-methylpropionamide) (Vam-110, available from FUJIFILM Wako Pure Chemical Corporation) | - | - | - | - | - |
| | Tackifier (parts by mass) | Hydrogenated rosin ester resin (KE-100, available from Arakawa Chemical Industries Ltd.) | - | - | - | - | - |
| | Crosslinking agent (parts by mass) | Isocyanate crosslinking agent (Coronate L-45K, available from Soken Chemical & Engineering Co.,Ltd.) | 0.2 | 0.2 | 0.2 | 0.2 | 0.2 |
| Substrate material | | | PEN | PEN | PEN | PEN | PEN |
| Bio-derived carbon content in adhesive layer (%) | | | 59 | 0 | 0 | 0 | 0 |
| Gel fraction of adhesive layer (% by mass) | | | 68 | 65 | 60 | 65 | 60 |
| Gel fraction of adhesive layer after curing (% by mass) | | | 68 | 99 | 95 | 65 | 60 |
| Shear storage modulus at 23°C of adhesive layer ($\times 10^5$ Pa) | | | 0.56 | 0.80 | 1.22 | 0.80 | 1.22 |
| Tensile storage modulus at 23°C of adhesive layer after curing ($\times 10^6$ Pa) | | | 0.17 | 21.9 | 30.0 | 0.23 | 0.36 |
| 180° Peeling force of adhesive tape for SUS (N/25 mm) | | | 5.9 | 8.2 | 10.0 | 8.2 | 10.0 |

(continued)

| | | | Comparative Example 1 | Comparative Example 2 | Comparative Example 3 | Comparative Example 4 | Comparative Example 5 |
|---|---|---|---|---|---|---|---|
| 180° Peeling force of adhesive tape after curing for SUS (N/25 mm) | | | 5.9 | 0.11 | 0.14 | 8.2 | 10.0 |
| Evaluation | Irregularities-filling properties | | ○○ | ○○ | × | ○ | × |
| | Removability | Residue | × | × | × | × | × |
| | | Wafer cracking | × | ○ | ○ | × | × |

INDUSTRIAL APPLICABILITY

The present invention can provide an adhesive composition that can achieve both excellent filling properties for irregularities and excellent removability. The present invention can provide an adhesive tape including an adhesive layer containing the adhesive composition. The present invention also can provide a method for processing a semiconductor wafer using the adhesive tape and a method for producing a semiconductor device using the adhesive tape.

**Claims**

1.  An adhesive composition comprising

    a (meth)acrylic copolymer,
    the (meth)acrylic copolymer containing a structural unit derived from n-heptyl (meth)acrylate,
    the (meth)acrylic copolymer having a carbon-carbon double bond in a side chain.

2.  The adhesive composition according to claim 1,
    wherein the structural unit derived from n-heptyl (meth)acrylate is contained in a proportion of 15% by mass or more in the (meth)acrylic copolymer.

3.  The adhesive composition according to claim 1 or 2,
    wherein the (meth)acrylic copolymer has a carbon-carbon double bond equivalent of 0.05 meq/g or greater.

4.  The adhesive composition according to claim 1, 2, or 3,
    wherein the (meth)acrylic copolymer contains a structural unit derived from a polar functional group-containing monomer.

5.  The adhesive composition according to claim 4,
    wherein the structural unit derived from a polar functional group-containing monomer is contained in a total proportion of 0.01% by mass or more and 30% by mass or less in the (meth)acrylic copolymer.

6.  The adhesive composition according to claim 4 or 5,
    wherein the (meth)acrylic copolymer has an acid value of 10 mg KOH/g or less.

7.  The adhesive composition according to claim 4, 5, or 6,
    wherein the (meth)acrylic copolymer has a hydroxy value of 5 mg KOH/g or greater and 100 mg KOH/g or less.

8.  The adhesive composition according to claim 1, 2, 3, 4, 5, 6, or 7,
    wherein the (meth)acrylic copolymer has a weight average molecular weight of 200,000 or greater and 2,000,000 or less.

9.  The adhesive composition according to claim 1, 2, 3, 4, 5, 6, 7, or 8, further comprising a photopolymerization initiator.

10. The adhesive composition according to claim 1, 2, 3, 4, 5, 6, 7, 8, or 9, further comprising an inorganic filler.

11. The adhesive composition according to claim 1, 2, 3, 4, 5, 6, 7, 8, 9, or 10, further comprising a polyfunctional oligomer or a polyfunctional monomer.

12. The adhesive composition according to claim 1, 2, 3, 4, 5, 6, 7, 8, 9, 10, or 11, further comprising a gas generating agent.

13. The adhesive composition according to claim 1, 2, 3, 4, 5, 6, 7, 8, 9, 10, 11, or 12, further comprising a tackifier.

14. An adhesive tape comprising
    an adhesive layer containing the adhesive composition according to claim 1, 2, 3, 4, 5, 6, 7, 8, 9, 10, 11, 12, or 13.

15. The adhesive tape according to claim 14,
    wherein the adhesive layer has a bio-derived carbon content of 10% or more.

**16.** The adhesive tape according to claim 14 or 15,

wherein the adhesive layer has a gel fraction of 10% by mass or more and 90% by mass or less, and the adhesive layer has a gel fraction of 90% by mass or more after heating at 150°C for one hour or after irradiation with light of any of the wavelengths in the range from 280 nm to 405 nm at an accumulated light dose of 1,000 mJ/cm$^2$ or greater.

**17.** The adhesive tape according to claim 14, 15, or 16,

wherein the adhesive layer has a shear storage modulus at 23°C of $1.2 \times 10^5$ Pa or less, and the adhesive layer has a tensile storage modulus at 23°C of $1.0 \times 10^6$ Pa or greater after heating at 150°C for one hour or after irradiation with light of any of the wavelengths in the range from 280 nm to 405 nm at an accumulated light dose of 1,000 mJ/cm$^2$ or greater.

**18.** The adhesive tape according to claim 14, 15, 16, or 17,

wherein the adhesive tape has a 180° peeling force for SUS of 0.3 N/25 mm or greater, and the adhesive tape has a 180° peeling force for SUS of 0.3 N/25 mm or less after heating at 150°C for one hour or after irradiation with light of any of the wavelengths in the range from 280 nm to 405 nm at an accumulated light dose of 1,000 mJ/cm$^2$ or greater.

**19.** The adhesive tape according to claim 14, 15, 16, 17, or 18, which is used for temporarily fixing a semiconductor wafer.

**20.** A method for processing a semiconductor wafer, comprising the step of temporarily fixing a semiconductor wafer to a support using the adhesive tape according to claim 19, curing the adhesive layer with light or heat, and then removing the adhesive tape.

**21.** A method for producing a semiconductor device, comprising the step of temporarily fixing a semiconductor wafer to a support using the adhesive tape according to claim 19, curing the adhesive layer with light or heat, and then removing the adhesive tape.

## INTERNATIONAL SEARCH REPORT

| International application No. |
|---|
| **PCT/JP2024/006916** |

| A. | CLASSIFICATION OF SUBJECT MATTER |
|---|---|

*C09J 133/04*(2006.01)i; *C09J 7/38*(2018.01)i; *C09J 11/04*(2006.01)i; *C09J 11/06*(2006.01)i; *C09J 11/08*(2006.01)i;
*H01L 21/301*(2006.01)i
FI: C09J133/04; C09J11/06; C09J11/04; C09J11/08; C09J7/38; H01L21/78 M

According to International Patent Classification (IPC) or to both national classification and IPC

| B. | FIELDS SEARCHED |
|---|---|

Minimum documentation searched (classification system followed by classification symbols)

C09J1/00-201/10; H01L21/301

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2022/270565 A1 (SEKISUI CHEMICAL CO., LTD.) 09 December 2022 (2022-12-09) claims 1-6, paragraphs [0013]-[0016], [0062]-[0067], table 1, examples 1-16 | 1-21 |
| A | EP 2626397 A1 (TESA AG) 14 August 2013 (2013-08-14) claim 1, paragraphs [0100]-[0105], examples 4, 4a | 1-21 |
| A | JP 2010-62542 A (NITTO DENKO CORPORATION) 18 March 2010 (2010-03-18) claim 1, paragraphs [0051], [0094]-[0098], [0010]-[0104], table 1, examples 1-13 | 1-21 |
| A | KR 10-1270976 B1 (IAC IN NAT UNIV CHUNGNAM) 11 June 2013 (2013-06-11) claim 1, paragraphs [0044]-[0063], table 1, examples 1-2 | 1-21 |
| A | WO 2006/112420 A1 (KANEKA CORP.) 26 October 2006 (2006-10-26) claims 1, 19, paragraphs [0015], [0123]-[0125], [0128]-[0130], examples 1-3 | 1-21 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **23 April 2024** | **14 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/006916**

| Patent document cited in search report | | | Publication date (day/month/year) | Patent family member(s) | | | Publication date (day/month/year) |
|---|---|---|---|---|---|---|---|
| WO | 2022/270565 | A1 | 09 December 2022 | CN | 116867868 | A | |
| | | | | TW | 202309220 | A | |
| EP | 2626397 | A1 | 14 August 2013 | DE | 102012201913 | A | |
| | | | | DK | 2626397 | T | |
| | | | | ES | 2684744 | T | |
| | | | | PT | 2626397 | T | |
| JP | 2010-62542 | A | 18 March 2010 | US | 2010/0029060 | A1 | |
| | | | | claim 1, paragraphs [0058], [0103]-[0106], [0126]-[0136], table 1, examplese 1-13 | | | |
| | | | | EP | 2151858 | A2 | |
| | | | | CN | 101645425 | A | |
| | | | | KR | 10-2010-0015290 | A | |
| | | | | TW | 201013767 | A | |
| KR | 10-1270976 | B1 | 11 June 2013 | (Family: none) | | | |
| WO | 2006/112420 | A1 | 26 October 2006 | US | 2009/0082488 | A1 | |
| | | | | claims 1, 19, paragraph [0021], examples 1-3 | | | |
| | | | | EP | 1873175 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015052050 A
- JP 2015021067 A

- JP 2015120876 A